# EUROPEAN PATENT APPLICATION

(11) **EP 4 730 387 A2**
(43) Date of publication of application: **22.04.2026**
(21) Application number: 25200341.3
(22) Date of filing: 04.09.2025
(51) Int. Cl.: H01J 37/22

(54) **ACQUIRING AND ENCODING ELECTRON MICROSCOPE GENERATED IMAGES**

(30) Priority: 26.09.2024 US 202418897649
(71) Applicant: FEI COMPANY, Hillsboro, OR 97124 (US)
(72) Inventor: Franken, Erik, Nuenen (NL); Janssen, Bart, Eindhoven (NL); Mulder, Jaap, Eindhoven (NL); Deng, Yuchen, Eindhoven (NL); Yu, Lingbo, Veldhoven (NL)
(74) Representative: Tombling, Adrian George

(57) **Abstract**

A method including configuring a transmission electron microscope according to first acquisition settings that comprise at least one of a first dose rate or a first operating mode. The method further including operating, during a first time period, the electron microscope to image a radiation-sensitive sample in accordance with the first acquisition settings. The method further including, after the first time period, configuring the electron microscope according to second acquisition settings that comprise at least one of a second dose rate different than the first dose rate or a second operating mode different than the first operating mode. The method further including operating, during a second time period, the electron microscope to image the radiation-sensitive sample in accordance with the second acquisition settings. The method further including generating image data based on first data and second data respectively collected during the first time period and the second time period

## Description

### BACKGROUND

Charged particle microscopy, such as transmission electron microscopy (TEM) and scanning electron microscopy (SEM), can use an array of detection techniques to obtain information about a sample. SEM and TEM techniques may be used to image various types of samples including surfaces/interiors of cells, structures of protein molecules, organization of molecules in viruses and cytoskeletal filaments, etc. Obtained information about the sample may be represented using a large amount of data (e.g., occupy a large amount of memory space).

### BRIEF SUMMARY

In some embodiments, a computer-implemented method includes configuring a transmission electron microscope according to first acquisition settings that comprises at least one of a first dose rate or a first operating mode. The computer-implemented method further includes operating, during a first time period, the transmission electron microscope to image a radiation-sensitive sample in accordance with the first acquisition settings. The computer-implemented method further includes after the first time period, configuring the transmission electron microscope according to second acquisition settings that comprises at least one of a second dose rate different than the first dose rate or a second operating mode different than the first operating mode. The computer-implemented method further includes operating, during a second time period, the transmission electron microscope to image the radiation-sensitive sample in accordance with the second acquisition settings. The computer-implemented method further includes generating image data based on first data and second data respectively collected during the first time period and the second time period.

In some embodiments, a non-transitory computer-readable storage medium comprising instructions that are executable by one or more processors of a transmission electron microscope for causing operations includes configuring the transmission electron microscope according to first acquisition settings that comprises at least one of a first dose rate or a first operating mode. The operations further include operating, during a first time period, the transmission electron microscope to image a radiation-sensitive sample in accordance with the first acquisition settings. The operations further include after the first time period, configuring the transmission electron microscope according to second acquisition settings that comprises at least one of a second dose rate different than the first dose rate or a second operating mode different than the first operating mode. The operations further include operating, during a second time period, the transmission electron microscope to image the radiation-sensitive sample in accordance with the second acquisition settings. The operations further include generating image data based on first data and second data respectively collected during the first time period and the second time period

In some embodiments, a transmission electron microscope includes one or memories storing instructions and one or more processors configured to execute the instructions to cause the transmission electron microscope to perform operations. The operations include configuring the transmission electron microscope according to first acquisition settings that comprises at least one of a first dose rate or a first operating mode. The operations further include operating, during a first time period, the transmission electron microscope to image a radiation-sensitive sample in accordance with the first acquisition settings. The operations further include after the first time period, configuring the transmission electron microscope according to second acquisition settings that comprises at least one of a second dose rate different than the first dose rate or a second operating mode different than the first operating mode. The operations further include operating, during a second time period, the transmission electron microscope to image the radiation-sensitive sample in accordance with the second acquisition settings. The operations further include generating image data based on first data and second data respectively collected during the first time period and the second time period.

### BRIEF DESCRIPTION OF THE DRAWINGS

The foregoing aspects and many of the attendant advantages of the present disclosure will become more readily appreciated as the same become better understood by reference to the following detailed description, when taken in conjunction with the accompanying drawings.
FIG. 1 is an example illustration of a system for acquiring image data and encoding the image data, according to some embodiments.
FIG. 2 is a schematic diagram of an electron microscope system, according to some embodiments.
FIG. 3 is a chart illustrating different dose rate schedules, according to some embodiments.
FIG. 4 is a chart illustrating Detective Quantum Efficiency loss as a function of accumulated dose, according to some embodiments.
FIG. 5 is a schematic diagram depicting an example of an image processing system, according to some embodiments.
FIG. 6 is a schematic diagram depicting an example of an compression system, according to some embodiments.
FIG. 7 is a schematic diagram depicting an example of a generative adversarial network for training an image generation model, according to some embodiments.
FIG. 8 is a schematic diagram depicting an example architecture of an image generation model, according to some embodiments.
FIG. 9 is a flow diagram of an example process for using a generative adversarial network to train an image generation model, according to some embodiments.
FIG. 10 is a flow diagram of an example process for generating encoding image data, according to some embodiments.
FIG. 11 is a flow diagram of an example process for acquiring image data, according to some embodiments.
FIG. 12 is a flow diagram of an example process for encoding image data, according to some embodiments.
FIG. 13 is a flow diagram of an example process for compressing image data, according to some embodiments.
FIG. 14 is a flow diagram of an example process for acquiring image data and encoding the image data, according to some embodiments.
FIG. 15 depicts a schematic diagram of an example computer system usable with systems and methods according to some embodiments of the present disclosure.

In the drawings, like reference numerals refer to like parts throughout the various views unless otherwise specified. Not all instances of an element are necessarily labeled to reduce clutter in the drawings where appropriate. The drawings are not necessarily to scale, emphasis instead being placed upon illustrating the principles being described.

### DETAILED DESCRIPTION

Charged beam particle systems that are used in electron microscopy provide high-resolution imaging by detecting signal electrons (e.g., backscattered electrons, secondary electrons, or the like) produced by the elastic scattering of a beam of electrons emitted from an electron emitter that interact with atoms of a sample. In one example, the electrons may be emitted from a cathode electrode that is heated by an electric current. The emitted electrons are attracted to an anode placed downstream of the cathode electrode, thus forming an electron beam directed to, and interacting with, the sample. The current of the signal electrons emitted from the electron beam interacting with the sample are measured by one or more electron detectors. This current can be used to generate a high-resolution image of the sample and be represented as image data.

In conventional charged beam particle systems, image data may be obtained by an image acquisition system over a period of time according to acquisition settings (e.g., dose rate, operating mode, a duration, and/or a magnification). The acquisition settings may cause more or less image data to be obtained. Additionally, the acquisition settings may cause the sample to degrade faster or slower than other image acquisition settings. Further, the acquisition settings can affect how much time is needed to obtain a predetermined amount and/or quality of image data. After image data is obtained, storing, transmitting, and/or using the image data may be limited or use many resources (e.g., storage resources, processing resources, network resources) because the image data may be large in size.

The present disclosure discloses techniques for using two or more acquisition settings over the period of time image data is collected to maximize the amount information and the quality of information obtained from a sample in a given period of time. The present disclosure also disclose techniques that can encode image data and/or compress image data to reduce the resources used by encoded image data compared to image data. Techniques disclosed herein may be independently used of other techniques or may be combined, which may enable more substantial benefits.

In general, encoded data represents data in a different form. As a basic example of encoding, a decimal number 10 can be encoded into hexadecimal and represented in a hexadecimal representation as 0xA. The decimal to hexadecimal encoding scheme enables the decimal number representation to be represented in a hexadecimal number representation and the hexadecimal to decimal encoding scheme enables the hexadecimal number representation to be represented in the decimal number representation.

Compression is a type of encoding. Compression may be performed to reduce the number of symbols used to represent a given piece of information. Compressed information may be decompressed/uncompressed. Compression may be lossy or lossless. With lossless compression, all data may remain after the data is decompressed. In other words, all the information represented before the data was compressed is restored after compressions and subsequent decompression. On the other hand, with lossy compression, the amount of data is reduced by permanently eliminating certain information. With lossy compression, all data may not remain after the data is decompressed. In other words, all the information represented before the data was compressed may not be restored after compressions and subsequent decompression. For example, lossy compression may eliminate data that is not needed for the application domain at hand (e.g., image or video compression where lossy compression leads to artifacts in the decompressed images that are not or are hardly visible to a human observer).

In a first particular example, acquisition settings of an electron-based imaging system may be adjusted (e.g., based on a schedule, based on user input, etc.) during different time windows of acquiring one or more images of a sample. The settings may dynamically adjust based on time, the sample being images, an accumulated dose, and/or other factors. In a specific example, a dose rate of the acquisition settings may be adjusted over time such that the dose rate increases over time.

The techniques described herein, including those described as the first particular example, may provide multiple technical improvements, benefits, and advantages with respect to prior solutions. For example, conventionally a single set of acquisition settings may be used to generate an image of a sample. Techniques described herein can optimize the imaging process such as by enabling the same image to be obtained in less time, to enable a better image to be acquired in the same amount of time, etc. Image acquisition techniques described herein can also reduce the amount of noise in images acquired compared to traditional techniques which may thereby reduce the resources (e.g., network resources, processing resources, storage resources) used to process, transmit, and/or store the images.

**In** a second particular example, a data encoding scheme may be used to encode image data generated by an image acquisition system. The image data may or may not have been acquired using the techniques for dynamically adjusting image acquisition settings described above. The encoding scheme may be configured to encode the image data based on the acquisition settings used to generate the image data.

The techniques described herein, including those described as the second particular example, may provide multiple technical improvements, benefits, and advantages with respect to prior solutions. For example, conventionally encoding schemes may be static/preconfigured and therefore may encode all image data using the same encoding scheme. Since techniques described herein can encode the image data based on the acquisition settings used to generate the image data, the encoding scheme used can be selected based on the encoding scheme that is optimal for encoding the image data. For example, when image data includes information with little noise, an optimal encoding scheme may be one that is less lossy. Further, when image data includes information with lots of noise, an encoding scheme that is more lossy may be optimal because more data can be afforded to be discarded while retaining the same structural information included in the image and while reducing the memory space occupied by the encoded image data compared to the image data before being encoded. The encoding techniques are able to reduce the resources (e.g., network resources, processing resources, storage resources) used to process, transmit, and/or store the encoded images compared to the images before being encoded.

One such encoding scheme may be a machine learning model that has been trained to encode image data. The model may have been trained in various ways, such as using a Generative Adversarial Network (GAN). The model may have been trained using image data and encoded image data as training data such that that model has been trained to generate encoded image data based on image data. The encoded image data generated by the model may occupy less memory space than the received image data such that less resources (e.g., memory, processing, and/or network) are used by the encoded image data generated by the model compared to the image data received.

**In** a third particular example, encoded image data can be subsequently encoded such that it is compressed and furthermore reduces the resources (e.g., network resources, processing resources, storage resources) used to process, transmit, and/or store the compressed images compared to the images before being compressed. Compressing the encoded image data may occur after determining reference information. The reference information may include the most likely particle positions and other sample information included in the image data. The reference information may be used to determine how to compress the image data based on the reference information to be retained in the compressed data.

The techniques described herein, including those described as the third particular example, may provide multiple technical improvements, benefits, and advantages with respect to prior solutions. For example, conventionally large amounts of data are generated by image acquisition systems and resources to store, process, and transmit the image data can be large in number and/or size. Techniques described herein can reduce the resources to store, process, and transmit image data by compressing the image data in a manner that loses less valuable information and/or further compresses the information compared to traditional compression techniques.

Although the remaining portions of the description will routinely reference transmission electron microscopes (TEM), it will be readily understood by the skilled artisan that the technology is not so limited. The present designs may be employed with other types of charged particle microscopes, such as scanning electron microscopes (SEM), scanning transmission electron microscope (STEM), dual beam systems including an ion beam source and an electron beam source, reflection electron microscopes (REM), circuit editing microscopes, or the like. Accordingly, the disclosure and claims are not to be considered limited to any particular example microscope discussed, but can be utilized broadly with any number of electron microscopes that may exhibit some or all of the electrical or chemical characteristics of the discussed examples.

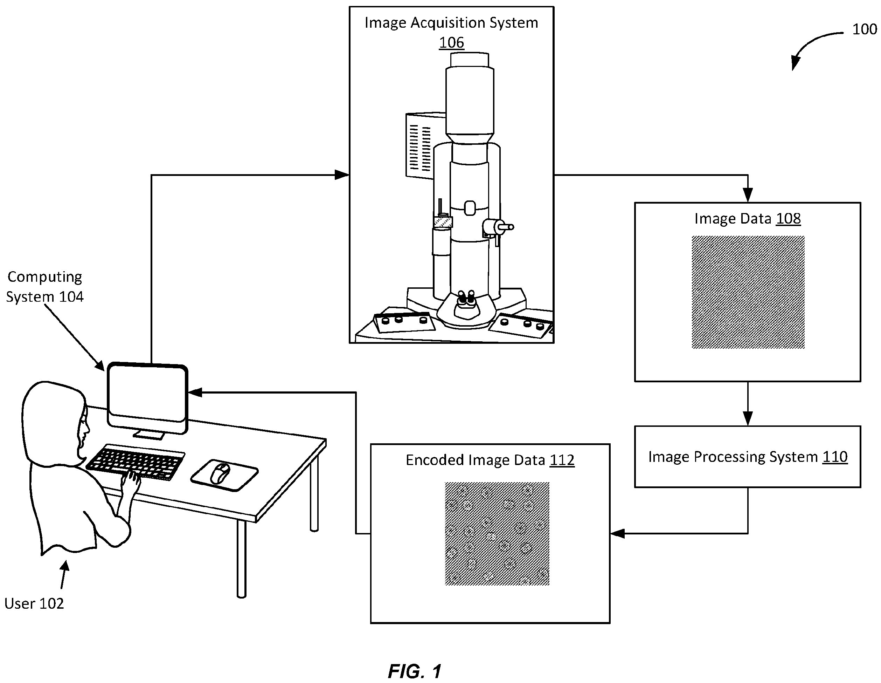

FIG. 1 is an example illustration of a system 100 for acquiring image data 108 and encoding the image data, according to some embodiments. The system 100 may include a computing system 104, an image acquisition system 106, and an image processing system 110.

Computing system 104 may be a user device (e.g., laptop, personal computer, phone, etc.). The computing system 104 may be a server. The computing system 104 may be capable of receiving input from a user 102 via, for example, a user interface. In certain embodiments, the input received by the computing system 104 includes an indication of operating mode (e.g., counting mode, integrating mode (also referred to as a sampling mode or a linear mode)), one or more dose rates, a length of time, sample information (e.g., sample material), and/or schedule information. The input may cause the computing system 104 to transmit image acquisition settings to the image acquisition system 106. The image acquisition settings may include any combination of the user input.

Image acquisition system 106 may include an electron microscope system (EMS). Image acquisition system 106 may generate image data based on data collected over one or more time periods. Image acquisition system 106 may be configured to operate according to one or more acquisition settings. The acquisition settings to operate the image acquisition system 106 may be based on the image acquisition settings received from computing system 104. The acquisition settings may be based on predetermined acquisition settings that may have been previously configured (e.g., by a user and or a system). The acquisition settings may be based on input received via a user interface of the image acquisition system 106, as described herein. In some embodiments, the acquisition settings may include at least a first acquisition setting including at least a first dose rate and/or a first operating mode. The acquisition setting may be configured based on user input, sample characteristics, purpose of imaging the sample, available resources (e.g., network resources, processing resources, memory resources).

Image acquisition system 106 may operate during a time period to image a radiation-sensitive sample in accordance with the acquisition settings. After the time period, image acquisition system 106 may be configured according to different acquisition settings, which may be obtained, generated, or otherwise selected using the techniques described herein. Image acquisition system 106 may operate during a second time period to image the radiation-sensitive sample in accordance with the different acquisition settings.

Image acquisition system 106 can generate image data 108 based on first sample data, second sample data, and/or other sample data collected during the first time period, second time period, and/or any other time period. Image data 108 may include one or more image stacks. An image stack may represent a plurality of images. Each image in the image stack may be an electron counted frame. The electron counted frame may be described using one or more electron coordinates.

Image processing system 110 may generate encoded image data 112 using image data 108. Image processing system 110 may receive image data 108 from image acquisition system 106 or another source of image data 108 (e.g., a datastore, computing system 104). Image processing system 110 may use one or more processing techniques to process image data 108 to generate encoded image data 112.

In certain embodiments, the processing technique may include using image processing system 110 to dynamically encode portions of the image data 108 based on the acquisition settings used in the process of obtaining the respective portion of image data 108. For example, if a first portion of image data 108 was obtained first acquisition settings and a second portion of image data 108 was obtained using a second acquisition setting, the first portion of image data 108 may be encoded using a different encoding scheme than the encoding scheme used to encode the second portion of image data 108.

In certain embodiments, the processing technique may include using image processing system 110 to encode image data 108 to generate intermediary encoded image data before compressing the intermediary encoded image data to generate compressed image data represented by encoded image data 112.

In certain embodiments, a processing technique may include image processing system 110 encoding image data 108 using an artificial intelligence (AI) model (e.g., a machine learning (ML) model) trained to generate encoded image data 112.

Image data 108 and/or encoded image data 112 may be transmitted to computing system 104 or a downstream consumer (e.g., a database). The processing described with respect to the system components of system 100 and other systems described herein may be performed using any combination of one or more devices. The processing may be performed locally and/or remotely from one or more devices.

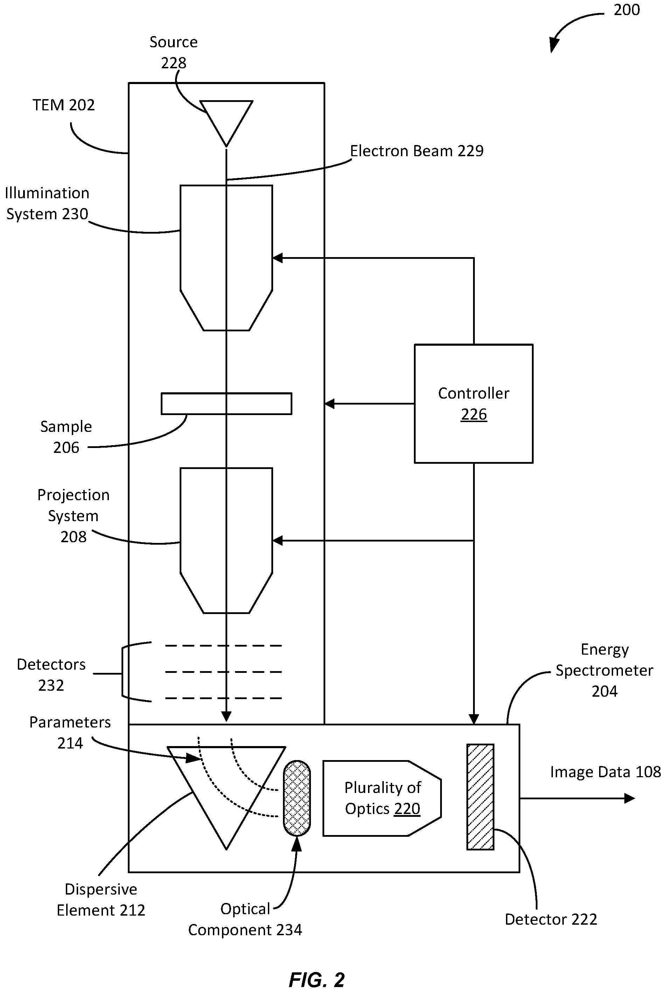

FIG. 2 is a schematic diagram of an electron microscope system (EMS) 200, according to some embodiments. EMS 200 is an example of an image acquisition system (e.g., image acquisition system 106 described herein). EMS 200 may include a TEM 202. TEM 202 can be used to acquire an image of sample 206. In some examples, TEM 202 can include an energy spectrometer 204. The energy spectrometer 204 may be used to obtain EEL spectra, for example. The EMS 200 may include an optical component to reduce or negate any defocusing problems that occur during acquisition of spectra. In some examples, the optical component can be biased to a level based on operating parameters of the EMS 200 and/or energy spectrometer 204 so that the refocusing is dynamic.

TEM 202 can include a source 228, an illumination system 230, a projection system 208, and various detectors 232, all of which can be controlled by controller 226. The source 228 may be an electron source, such as a Schottky source or a (cold) field emission gun (CFEG) and can provide a beam of electrons that propagate along an optical axis of TEM 202 to interact with a sample 206. The illumination system 230 can include a plurality of electronic optic components to condition an electron beam for delivery to the sample 206. Conditioning the electron beam may include collimation, astigmatism correction, and focusing the electron beam at a sample plane. The projection system 208 may include a variety of electrostatic/magnetic lenses, deflectors, correctors (e.g., stigmators), etc., that can be used to focus the electron beam emerging from the sample 206 onto one of the various detectors 232. The projection system 208 may be configured to focus an image of the sample 206 with a certain (adjustable) magnification at the detectors 232; this is commonly referred to as the "imaging mode" of the projection system. Alternatively, the projection system 208 may be configured to focus an image of the angular distribution of emerging electrons (or "diffraction pattern") with a certain (adjustable) magnification at the detectors 232. Such diffraction pattern is formed in the back-focal plane of the first magnifying lens (the "objective lens," not shown in FIG. 2). This alternative mode of the projection system is commonly called the "diffraction mode" and the magnification in this alternative mode is commonly referred to as the "camera length." However, for the sake of simplicity, where the present disclosure writes "images" or "focuses" or the like, this refers both to the "imaging mode" and to the "diffraction mode" of the imaging system. Similarly, where the present disclosure writes "magnification setting" or the like, this refers both to the "magnification setting" and "camera length setting" of the imaging system.

In some examples, the projection system 208 focuses and conditions the electron beam for delivery to the energy spectrometer 204. The various detectors 232 may individually be moved in and out of an optical path to provide different detection schemes for the TEM 202. The various detectors 232 may include an imaging screen, a TEM camera, and a STEM camera.

The energy spectrometer 204 can include dispersive element 212 (with bias tube 214), optical component 234, a plurality of optics 220, and detector 222. Many of the components of the energy spectrometer 204 were discussed with respect to FIG. 1 and will not be revisited for sake of brevity. Other components of the energy spectrometer 204 described in FIG. 1 that are not specifically shown in energy spectrometer 204 can be included but are left out of FIG. 2. An additional component, namely optical component 234, is included in energy spectrometer 204 to correct a gradient of focus of the electron energy loss spectrum across the detector as discussed. The optical component 234 can be a single element such as a magnetic hexapole. Alternatively, optical component 234 can include multiple multipole elements (quadrupoles, hexapoles, octupoles, and the like) which can be electric or magnetic in the nature of their operation. Also, apart from the refocusing of the spectrum, the optical component 234 may perform multiple alternative functions simultaneously or not simultaneously, such as correcting image distortions or correcting spectrum distortions. In FIG. 2, optical component 234 is shown downstream from dispersive element 212, but this is not the only location to arrange the optical component 234. In general, some elements of optical component 234 can be arranged upstream from the dispersive element 212 (but downstream from the sample 206), and some elements of the optical component 234 can be arranged downstream of the dispersive element 212 within or after the plurality of optics 220.

Controller 226 may include one or more processing cores and memory storing executable code. In addition, controller 226 may provide operating voltages to some components of the EMS 200 or be coupled to voltage supplies (not shown) that can provide operating voltages in response to control signals provided by the controller 226. For example, the controller 226 may provide control and/or voltages to illumination system 230, projection system 208, or optical component 234. Further, the controller 226 may control operation of detector 222 and/or receive data from detector 222. In general, the controller 226 can set the operating parameters of the EMS 200 and can adjust electrical bias of optical component 234 to dynamically focus the electron beam onto detector 222 in response to changes in operating conditions of the EMS 200, such as magnification.

Controller 226 may receive input (e.g., user input, input from a computing system) that configures EMS 200. EMS 200 may be configured according to an acquisition setting. The acquisition settings may include a dose rate, an operating mode, a duration (e.g., 1 second, 5 seconds, 10 seconds, etc.), and/or a magnification. The dose rate is the number of electrons for a period of time a sample being imaged receives. For example, a dose rate may be measured in electrons per second. The operating mode may include a counting mode or an integrating mode.

In the counting mode, individual electron events may be identified and the digital events may be accumulated over time. The image data 108 quality generated using the counting mode may decrease as dose rate increases over an operating range of the counting mode. For example, if too high of a dose rate is used, high coincidence loss occurs where all individual electrons are not capable of being localized since they are too close to each other in space-time.

In the integrating mode, a dose rate may be different (e.g., larger) than a dose rate in the counting mode. In the integrating mode, a max dose rate may depend on how linear a camera behaves in the used range, and how as a pixel saturates to its max value. The image quality of the generated image data 108 may be constant as a function of dose rate. The dose rate may have a fixed image quality (that can be referred to as Detective Quantum Efficiency (DQE)) that is worse compared to the image quality obtained using the counting mode. The integrating mode may have an operating range that is different (in part (e.g., overlaps) or as a whole (disjoint)) than the operating range of the counting mode. The integration mode may be used during acquisition to accommodate for very large doses. In an example where 100 electrons per pixel total dose with electron counting doses of 0.025 electrons per pixel is desired, the integration mode may be used because of the desired high dose.

Controller 226 may configure EMS 200 to operate for a time period in accordance with acquisition settings to collect sample data of the sample 206. The sample 206 may be a radiation-sensitive sample. EMS 200 may generate image data 108 as a result of the sample data. In certain embodiments, the image data 108 is the sample data. In certain embodiments, first sample data and second sample data or combined to represent the image data 108.

In certain embodiments, controller 226 may configure EMS 200 to operate, during a first time period, in accordance with first acquisition settings to image sample 206. Controller 226 may subsequently configure EMS 200 to operate, during a second time period, in accordance with second acquisition settings to image sample 206. During each time period, sample data may be collected that may be used to generate image data 108. The first acquisition settings may be the same or different acquisition settings as the second acquisition settings. A dose rate of the second acquisition settings may be different (e.g., greater) than a dose rate of the first acquisition setting. An operating mode of the second acquisition settings may be different than an operating mode of the first acquisition settings. The second time period may be a different length of time than the first time period. The time period to operate the EMS 200 using acquisition settings may be determined by the rate of radiation damage the sample 206 incurs. The time period to operate the EMS 200 according to acquisition settings may be based on previous acquisition settings, dose rate, and/or operating mode. Furthermore, the controller 226 may configure the frame rate used to obtain data using EMS 200. The frame rate may be different during the second time period compared to the first time period.

In certain embodiments, controller 226 may configure EMS 200 to operate during any number of time periods, in accordance with the first acquisition settings, the second acquisition settings, or other acquisition settings to image the sample 206. The acquisition settings may be determined according to a time-dependent function (e.g., an exponential function, a linear function), user input, based on a purpose of imaging the sample 206, and/or an expected radiation damage characteristic of the sample 206.

When sample 206 is radiation sensitive, sample 206 can degrade as dose is accumulated (e.g., as more electrons interact with the sample). Due to radiation damage, electrons detected at the end of an acquisition period can carry less information about the sample than the ones detected in the beginning of the acquisition period. Additionally, events detected in a high dose-rate frame can carry less information about the imaged sample 206 than events detected in a low dose-rate frame. Image data 108 obtained from EMS 200 may be more accurate at lower dose rates than higher dose rates. The image quality (e.g., accuracy) of the image data 108 may degrade as dose-rate increases. Certain embodiments can maximize the amount information obtained from sample 206 in a given period of time.

In an example, controller 226 may cause a change to the acquisition settings during image data 108 acquisition. For example, the controller 226 may configure EMS 200 to acquire first sample data in counting mode for 0.5 seconds at a dose rate of 4 electrons per second (e/p/s). After the 0.5 seconds, controller 226 may configure EMS 200 to acquire second sample data in integration mode (e.g., single sampling mode) for 2 frames (e.g., 2/320 seconds) at a dose rate of 6080 electrons per second (e.g., 19 electrons per pixel per frame). The first sampling data may represent a first frame or set of frames of image data 108 and the second sample data may represent a second frame or set of frames of image data. The first sample data and the second sample data may be combined (e.g., concatenated) to generate image data 108. Controller 226 may combine the two or more sample data into image data 108.

To increase the speed at which acquisition settings can be changed, a shutter may be used (e.g., with a PWM-modulated fast blanker). The acquisition settings may be set to a maximum desired dose rate and a fast shutter enabled to turn on and off at a given frequency (e.g., high frequency, low frequency) or at a camera frame rate (e.g., high camera rate, low camera rate). The shutter rate may be used to control the dose rate. For example, the shutter rate may be capable of being changed (e.g., by the controller 226) from a first shutter rate to a second shutter rate that is greater or less than the first shutter rate (e.g., changed to be 1/10 the first shutter rate). By altering the shutter rate, the acquisition settings can be changed in a time period that is shorter than other methods of changing acquisition settings. For example, the shutter rate may be changed in less than 1 second versus other techniques taking multiple seconds to change acquisition settings.

In embodiments where one or more acquisition settings (e.g., dose rate) is adjusted as a function of accumulated dose, sample 206 may be illuminated at a low dose rate when relatively little radiation damage has occurred to sample 206 (e.g., up to 1 electron per angstrom²). Further, where a dose rate is adjusted as a function of accumulated dose, sample 206 may be illuminated at a higher dose rate when increased radiation damage to sample 206 has occurred. Such a dynamic dose-rate schedule can be optimized such that maximal information (e.g., high quality image data 108) is obtained from the sample 206 for a fixed period of acquisition time. Such acquisition methods may generate high quality image data 108 and image data 108 that occupies less memory space compared to other acquisition methods. Image data 108 that takes up less memory space can be transmitted and used by other systems with less computational resource (e.g., network, processing) overhead.

Optical component 234 may be formed from a multipole element containing two or more electrically conductive elements. In some examples, optical component 234 is formed from two opposing conductive elements, similar to a deflector-or shutter-type arrangement, housed in a conductive body. In other examples, the optical component 234 is formed from a quadrupole or higher order multipole element. The excitation of optical component 234 can be of electric or magnetic nature or a combination of these, or more generally, can be of an electromagnetic nature. Regardless of the physical example, the optical component 234 may be excited to a level based on operating parameters of TEM 202 and/or energy spectrometer 204. Any combination of the dispersive element 212, the optical component 234, and the plurality of optics 220 may be used. For example, in certain embodiments, none of the dispersive element 212, the optical component 234, and the plurality of optics 220 are included in EMS 200.

In operation, an electron beam generated by source 228 at a primary energy can be projected toward sample 206, where the electron beam interacts with the sample 206. The interaction may result in some of the electrons losing energy by an amount associated with various material characteristics of the sample 206. The electron beam emerging from the sample 206 may then include electrons of different energies across a range of energies. The emerging electron beam may then propagate at different trajectories than the electrons of the primary energy, which can affect focal points, e.g., crossover locations, along a rest of the optical path including the energy spectrometer 204 and the TEM 202. In some examples, operations of any component that may adjust (steer) the electron beam may subsequently result in defocusing in the spectrum plane or may result in a gradient of focus across the spectrum plane. In this example, to refocus the electron beam, the optical component 234 can be excited based on current operating parameters. In various examples, exciting the optical component 234 can align cross-over locations with the spectrum plane, and thus the detector 222.

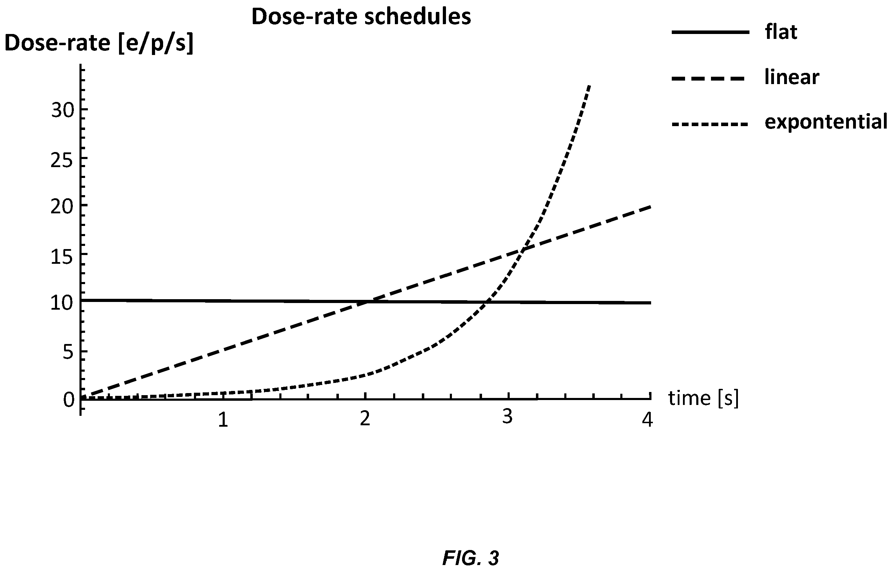

FIG. 3 is a chart 300 illustrating different dose rate schedules, according to some exemplary embodiments. The chart 300 has a Y-Axis representing dose rate in electrons per pixel per second. The X-axis is time. The chart illustrates three simple examples of dose rate schedules, a flat schedule, a linear schedule, and an exponential schedule. The flat dose rate schedule is not a dynamic dose rate schedule because the dose rate does not change over time. On the other hand, the linear dose rate schedule and the exponential dose rate schedule are examples of dynamic dose rate schedules because the dose rate changes over time.

Each of the example dose rate schedules in chart 300 accumulate about 40 electrons over a period of time (e.g., 4 seconds). The number of electrons accumulated over a dose rate schedule is equal to the area under the respective dose rate schedule curve. Chart 300 shows how the accumulation of electrons is affected by the dose rate.

Using the flat dose rate schedule at 10 electrons per pixel per second, 40 electrons are accumulated over a period of time of 4 seconds. Using the linear dose rate schedule that starts at 0 (or slightly above 0) and has a slope of 5 electrons per pixel per second per second, 40 electrons are accumulated over a period of time of 4 seconds. Using the exponential dose rate schedule that starts at 0, 40 electrons are accumulated over a period of time of about 3.5 seconds.

Each of the dose rate schedules shown induce different detection efficiencies. A detection efficiency of a dose rate can be visualized Detective Quantum Efficiency (DQE) as a function of accumulated dose. DQE as a function of accumulated dose is illustrated for each of the dose rate schedules in chart 400, described below.

For sake of example, only the above described simplistic dose rate schedules are shown in chart 300. One of ordinary skill in the art with the benefit of the present disclosure would recognize that other dose rate schedules are also possible and may be a function of time or another variable. Further, in certain embodiments, any combination of dose rate or other acquisition settings may change based on a function of time or a combination of variables.

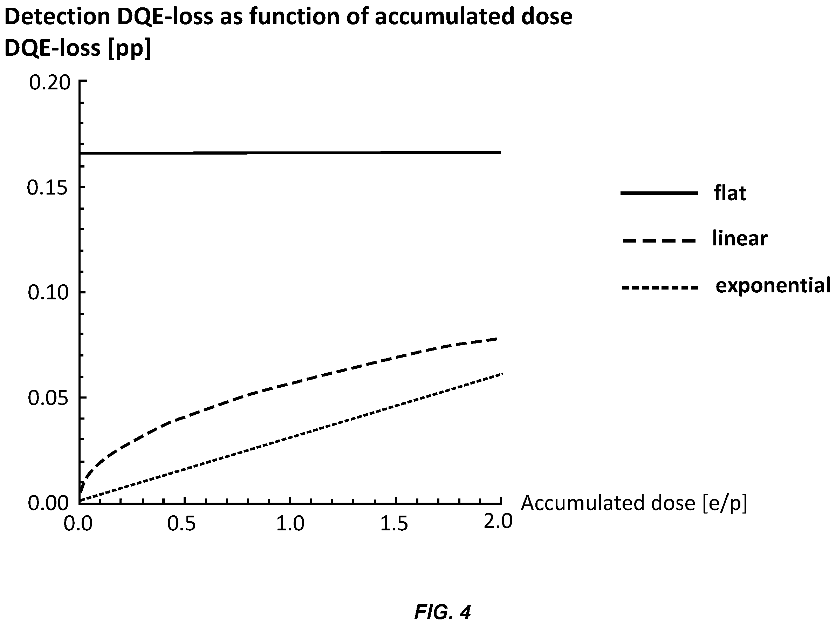

FIG. 4 is a chart 400 illustrating Detective Quantum Efficiency (DQE) loss as a function of accumulated dose, according to some exemplary embodiments. The dose rate schedules in chart 300 induce different detection efficiencies, visualized as DQE-loss (expressed in percentage points (e.g., 0.15 = 15%)) as a function of accumulated dose for the first 2 electrons in chart 400. The Y-Axis of chart 400 is DQE loss measured in percentage points. The X-axis of chart 400 is accumulated dose measured in electrons per pixel. DQE-loss may be a loss compared to an optimal DQE of a camera, (e.g., the DQE when using a lowest possible dose rate (which normally requires a large exposure time)).

The earlier an electron interacts with a sample (e.g., sample 206) compared to other electrons interacting with the sample, the less degradation will have occurred and therefore a higher quality of data can be obtained from the sample by the electron. Accordingly, the first two electrons carry more high-frequency information (as evidenced by the lower DQE-loss) about the sample (e.g., proteins) than later electrons (as evidenced by higher DQE-loss). The later an electron interacts with a sample compared to other electrons interacting with the sample, the more degradation will have occurred and therefore the electron will not carry as much information about the fine details of the sample. In certain embodiments, later electrons (e.g., electrons after the first electron and second electron) may be used for particle picking even though the information carried by later electrons may have a higher DQE-loss.

Chart 400 illustrates DQE-loss as a function of accumulated dose for each of the flat dose rate schedules, the linear dose rate schedule, and the exponential dose rate schedule from chart 300.

Chart 400 illustrates that for a first 2 electrons, the exponential dose rate schedule is equivalent to the flat dose rate flat schedule on a 70% faster camera. In other words, the amount of time to obtain the same image data (e.g., image data 108) can be reduced by 70% using the exponential dose rate schedule compared to the flat dose rate schedule. Further, the exponential dose rate schedule can obtain the same performance (e.g., DQE-loss) as the flat dose rate schedule using conventional imaging with 40 electrons in a five times shorter exposure (0.8 seconds). Because the DQE-loss is reduced using dynamic dose rate schedules compared to flat dose rate schedules, a reduction in storage requirements of acquired image data can result.

For the dynamic dose rate schedules, the DQE loss for a given accumulated dose is low compared to the flat schedule. The low DQE is not an issue because the sample to be imaged is already damaged by the end of the acquisition period (e.g., after previous electrons have interacted with the sample). Information acquired during the later part of the acquisition period may not be used to obtain high-resolution sample information. Information acquired during the later part of the acquisition period may be used for intermediate steps such as particle picking.

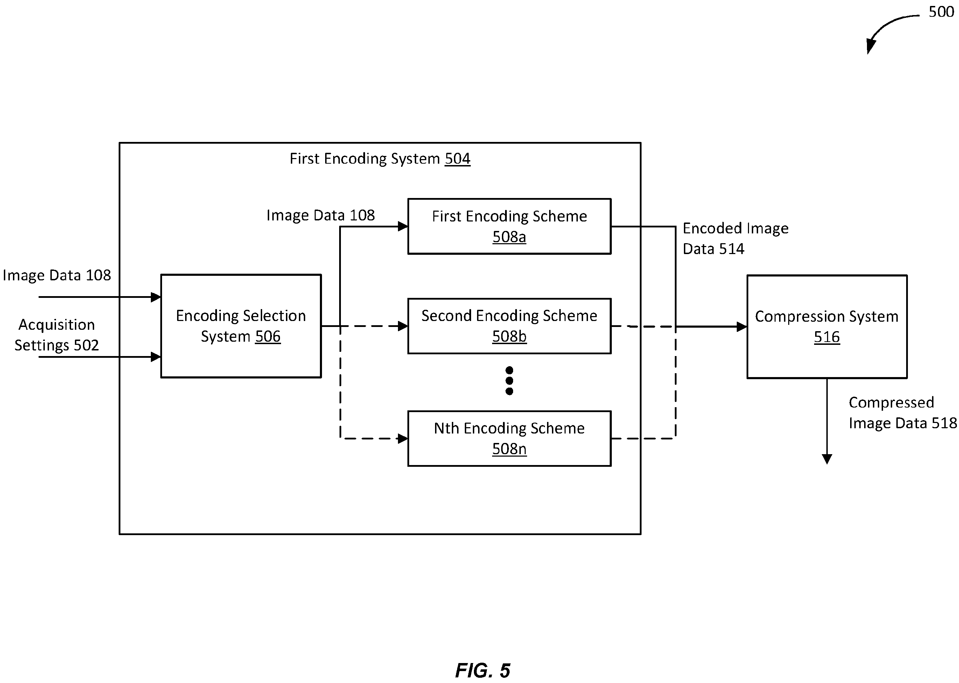

FIG. 5 is a schematic diagram depicting an example of an image processing system 500, according to some embodiments. Image processing system 500 may be part of image processing system 110 as described with respect to system 100. Image processing system 500 may include a first encoding system 504 and a compression system 516. In certain embodiments, image processing system 500 is used in combination with dynamic image acquisition settings 502 as described above. Image processing system 500 may be used to generate encoded image data 514 and/or compressed image data 518.

The first encoding system 504 may receive image data 108 and acquisition settings 502. Image data 108 may have been generated by an image acquisition system (e.g., image acquisition system 106, EMS 200). The acquisition settings 502 may have been used by EMS 200 to generate image data 108. The first encoding system 504 may include an encoding selection system 506 which may select an encoding scheme 508 from one or more encoding schemes as represented by the first encoding scheme 508a, the second encoding scheme 508b, through the Nth encoding scheme 508n. The first encoding system 504 may convert image data 108 into encoded image data 514 using an encoding scheme 508.

Encoding selection system 506 may receive image data 108 and acquisition settings 502 (e.g., dose rate). The encoding selection system 506 may dynamically compute an encoding scheme 508 to use for representing the image data 108. Each encoding scheme 508 may be used to encode the image data 108 into a different representation. The representation and encoding scheme 508 may be referred to as being dynamic because the encoding scheme 508 used may be based on the acquisition settings 502 and/or image data 108. The computation of the dynamic representation to use for representing the image data 108 may determine which of the available encoding schemes 508 will be selected to use to encode the image data 108. In certain embodiments, the acquisition settings 502 and/or image data 108 are used to compute the optimal encoding scheme 508 to encode the image data 108 with.

The encoding selection system 506 may determine a subsequent encoding scheme 508 to use after using a previous encoding scheme 508 after a predetermined period of time, when the acquisition settings 502 have changed, based on a total length of an exposure of the sample (e.g., sample 206) to electrons, and/or based on a portion of the total length of the exposure of the sample. The capability of the encoding selection system 506 to dynamically select the encoding scheme 508 to use based on acquisition settings 502 and/or other factors can enable the first encoding system 504 to generate encoded image data 514 that is dynamic/adaptive.

In an example, a first dynamic representation to use for representing first image data (a subset of image data from image data 108) is computed by the encoding selection system 506 based on at least a first acquisition setting. The first image data may be converted into a first spatio-temporal resolution representation using the first encoding scheme 508a. Further, a second dynamic representation to use for representing second image data (a subset of image data from image data 108) is computed by the encoding selection system 506 to represent second image data based on at least a second acquisition setting. The second image data may be received by the first encoding system after the first image data and may be part of the same sample imaging session (e.g., different portions of the image data 108 output from an image acquisition system). The second image data may be different image data than the first image data. The second image data may be converted into a second spatio-temporal resolution representation using the second encoding scheme 508b. The second dynamic representation may be different than the first dynamic representation. In the example, the first encoding system 506 is capable of dynamically encoding the image data such that the first image data is encoded using a different encoding scheme 508 than the second image data. The second encoding scheme 508b may be more lossy than the first encoding scheme 508a. The first spatio-temporal resolution representation/first encoded image data may include a higher spatio-temporal resolution compared to the second spatio-temporal resolution representation/second encoded image data.

By being capable of using different encoding schemes 508, high resolution sample information that may be included in the first image data may be encoded differently (e.g., with a higher spatio-temporal resolution representation) than lower resolution sample information that may be included in the second image data. The different encoding schemes 508 can reduce the amount of memory occupied by the encoded image data 514 and/or increase the spatio-temporal resolution of the encoded image data 514 compared to if a single encoding scheme 508 was used for the first image data and the second image data. The different encoding schemes 508 can minimize the amount of memory occupied by the encoded image data 514 while also maximizing the spatio-temporal resolution of the encoded image data 514. **In** certain embodiments, the first image data and the second image data may pass through one or more first encoding systems 504 in parallel. The first encoding system 504 can reduce redundant information and/or the amount of information discarded that includes relevant image data 108.

The encoding selection system 506 may select an encoding scheme 508 based on a number of electrons emitted, a number of electrons that have interacted with a given area of the sample, and/or a period of time, etc. The encoding schemes 508 included in the set of one or more encoding schemes and/or the factors considered by the encoding selection system 506 to select an encoding scheme 508 may be determined by an indication received from a graphical user interface of a user device (e.g., laptop, tablet, desktop, an image acquisition system, etc.).

After the encoding selection system 506 computes the dynamic representation to use for representing the image data 108, the encoding selection system 506 may cause the image data 108 to be encoded using an encoding scheme 508 (e.g., the first encoding scheme 508a) from the set of encoding schemes. The encoding selection system 506 may transmit the image data 108 to a selected encoding scheme 508. Encoding selection system 506 may otherwise cause the selected encoding scheme 508 to receive the image data 108.

The selected encoding scheme 508 may encode the image data 108 into encoded image data 514. The encoding scheme 508 may represent the image data 108 in a different/encoded representation. The encoding scheme 508 may or may not cause the encoded image data 514 to occupy less space in memory than the image data 108. The encoding scheme 508 may represent the image data 108 in a spatio-temporal resolution representation. Different encoding schemes 508 may cause the image data 108 to be represented in a higher spatio-temporal resolution representation and/or occupy less memory compared to other encoding schemes 508. **In** certain embodiments, an inverse encoding scheme to the one used to generate the encoded image data 514 using the image data 108 may be used to obtain the image data 108 from the encoded image data 514. **In** other words, the inverse of the encoding scheme (which can also be referred to as a decoding scheme) may be used to decode the encoded image data.

An example of an encoding scheme 508 may include an Electron Event Representation (EER). The EER may encode electron events as (X, Y, time). The event location can be stored on a gradually coarser spatio-temporal sampling grid. **In** certain embodiments, when the amount of electrons in each sampling grid coordinate gets too high, it may be more efficient to start encoding image data 108 using a different encoding scheme (e.g., a dose fractionation scheme).

Another example of an encoding scheme 508 may include a dose fractionation scheme. The dose fractionation scheme may include a fixed and/or moving spatio-temporal resolution. The fixed spatio-temporal resolution may keep the spatio-temporal resolution constant for the selected dose fractionation scheme. The moving spatio-temporal resolution may enable the spatio-temporal resolution to be adjusted based on image size, amount of camera frames per dose fractions, and/or other factors (e.g., acquisition settings 502). The dose fractionation scheme may divide ("fractionate") the total desired exposure dose of a certain amount of electrons per pixel, into partial exposure over time, to be able to correct for local and global motion. For example, if an exposure of 20 electrons per pixel is used to create 20 dose fractions, 20 images can be produced, each with 1 electron per pixel. The fractionation can be chosen independently from native frame rate of the camera, so it could be that the 20 electrons per pixel exposure leads to 1000 native frames; in that case each dose fraction therefore consists of 1000/20 frames = 50 frames.

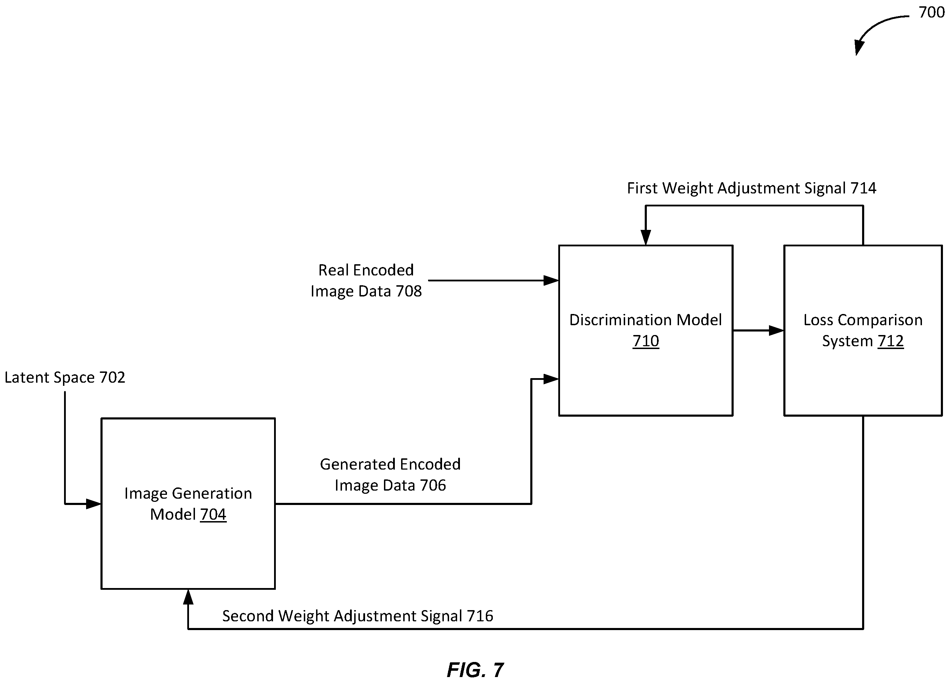

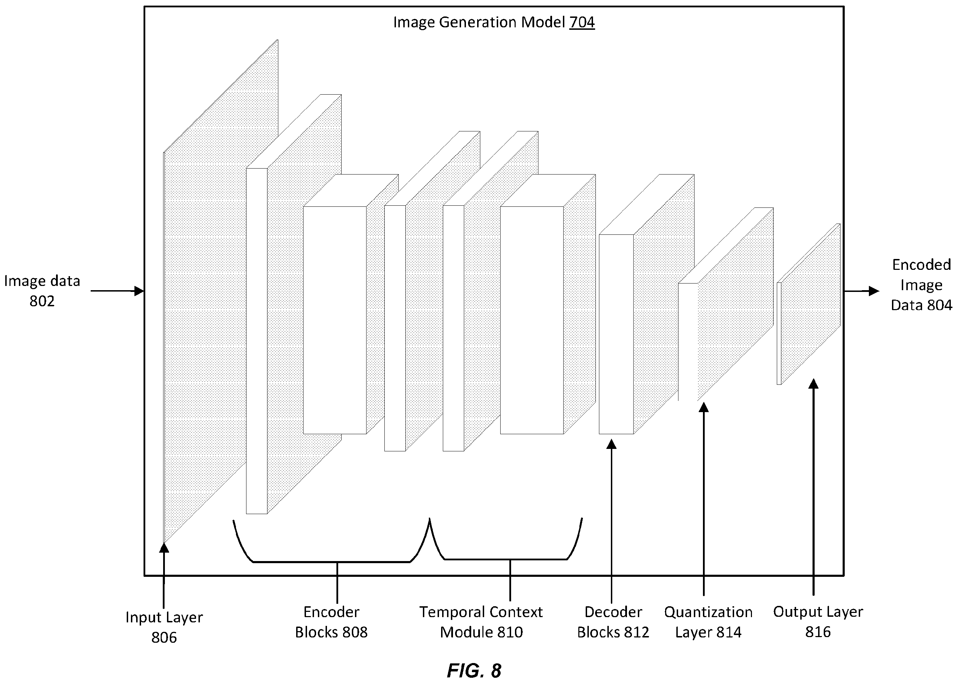

Another example of an encoding scheme 508 may include an image encoding-decoding model. The image encoding-decoding model may be trained to define encoded image data 514. The image encoding-decoding model may have been trained using a generative adversarial network (GAN). Embodiments of the image encoding-decoding model are described in more detail below (e.g., with respect to FIGS. 7 and 8, among other areas).

In certain embodiments, the set of encoding schemes may include more than one of a type of encoding scheme 508. For example, the set of encoding schemes may include a first encoding scheme 508a that is a first dose fractionation scheme configured in a first way and may also include a second encoding scheme 508b that is a second dose fractionation scheme configured in a second way.

The encoded image data 514 may be the encoded image data 112 described with respect to system 100. The encoded image data 514 may represent low dose image frames or electron events. In certain embodiments, first encoded image data generated using first image data represents electron events and second encoded image data generated using second image data represents low dose image frames. In certain embodiments, encoded image data 514 is encoded again by a compression system 516 to generate compressed image data 518. The compressed image data 518 may be the encoded image data 112 described with respect to system 100.

The compression system 516 may compress encoded image data 514 (e.g., image data represented in a spatio-temporal resolution representation) to generate compressed image data 518. In certain embodiments, the compression system 516 may generate compressed image data 518 based on the dynamic representation /encoding scheme 508 used with the image data 108. Since the compression system 516 may generate compressed image data 518 based on the dynamic representation /encoding scheme 508 used for the image data 108 the compression system 516 may dynamically generate first compressed image data based on a first encoding scheme used and dynamically generate second compressed image data based on a second encoding scheme used. In other words, a first portion of image data 602 may be compressed using a different compressions scheme than a second portion of image data 602.

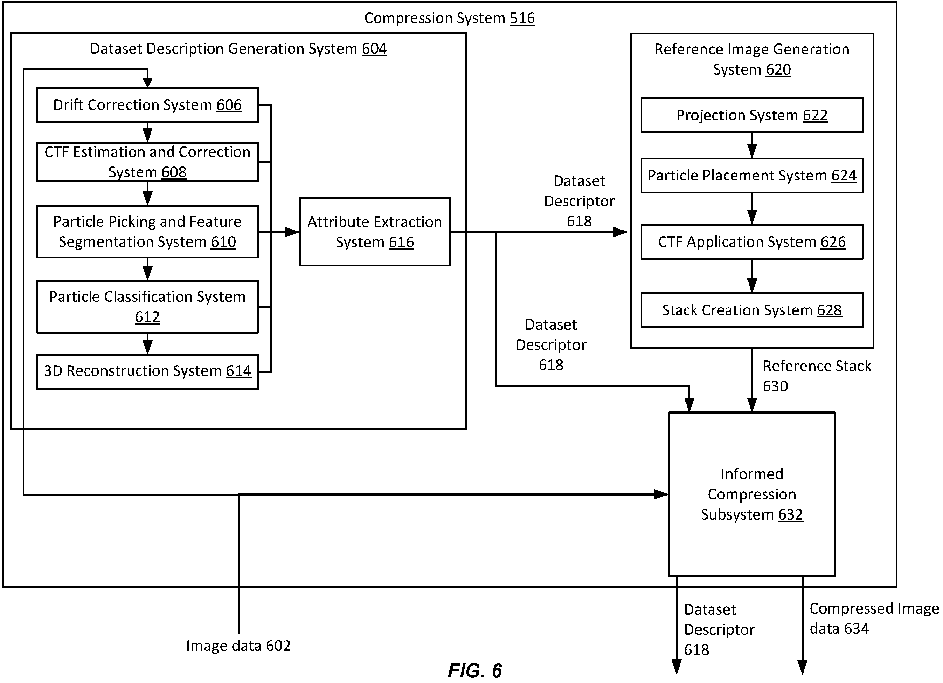

The compression system 516 may compress the encoded image data 514 into a compressed representation. In some embodiments, compression system 516 may use a compression scheme such as Lempel-Ziv-Welch (LZW) or a ZIP file to compress encoded image data 514. The compressed representation may be more or less lossy depending on the encoding scheme 508 used with the image data 108 to generate the encoded image data 514. A second encoding system is described in further detail with respect to FIG. 6.

FIG. 6 is a schematic diagram depicting an example of a compression system 516, according to some embodiments. Compression system 516 may be used to generate compressed image data 634. Compressed image data 634 may be the same compressed image data as compressed image data 518. The compressed image data 634 may be a compressed form of image data 602. Image data 602 may be represented in a spatio-temporal representation and received by compression system 516. Image data 602 may have been encoded into the spatio-temporal resolution (e.g., encoded image data 514). Compression system 516 may generate compressed image data 634 using image data 602. Compression system 516 may be used to generate an application-tailored data compression. Compressions system 516 may include a dataset description generation system 604, a reference image generation system 620, and an informed compression subsystem 632.

Compression system 516 may receive the image data 602 from a first encoding system (e.g., first encoding system 504), an image acquisition system (e.g., image acquisition system 106), and/or another image data source. The image data 602 may include high contrast image data 602 (e.g., image data obtained using TEM with phase plate or dark field imaging techniques). Image data 602 may include an image stack. The image stack may include data representing a plurality of images.

Dataset description generation system 604 may use image data 602 to generate a dataset descriptor 618. Dataset description generation system 604 may generate the dataset descriptor 618 using a drift correction system 606, a contrast transfer function (CTF) estimation and correction system 608, a particle picking system and/or a feature segmentation system 610, a particle classification system 612, a three-dimensional (3D) reconstruction system 614, an artificial intelligence model (not shown), and/or downsampled image data (not shown). In certain embodiments, dataset descriptor 618 may include a tomographic tilt series alignment (e.g., generated by a tomographic tilt series alignment method), a down sampled image (e.g., generated by a down sampled image generator), and/or encoded image data (e.g., generated by image generation model 704).

The drift correction system 606 may generate a drift profile for the image data 602 and/or each image stack. Drift correction system 606 can measure a drift for an image stack (e.g., each image stack independently of other image stacks). The drift may be a field of view shift as a function of time. Drift correction system 606 may be used to estimate local sample deformation (e.g., electron-beam-induced sample motion).

The contrast transfer function (CTF) estimation and correction system 608 may determine how much a phase shift and microscope aberrations have corrupted the image data 602. The parameters of the function may be determined by the CTF estimation and correction system 608. CTF estimation and correction system 608 may process image data 602 given the estimated phase shift and microscope aberrations such that the effect of them will be reduced or removed.

The particle picking system can find locations in image data 602 where there is likely a particle of interest. Since the particles are actually 3D object, while image data 602 are 2D, particle picking system searches for 2D projections of the 3D particle of interest. Various algorithms may be used by particle picking system such as generic methods which aim to find a "blob-like" structure within a given size range. Template matching methods may be used by particle picking system, where an earlier obtained 3D model is projected into multiple 2D template images with different projection directions, and those projected 2D template images are used as templates that are to be detected in the image data 602. Artificial intelligence algorithms can be used by particle picking system.

The feature segmentation system can be used to detect features not of interest for a 3D particle reconstruction but are of interest to describe the image data 602 (e.g., contaminations).

The particle classification system 612 groups picked particles into classes of particles with equal appearance. Particles with equal appearance are likely to have the same projection orientation. By combining particles with the same projection orientation, a denoised particle projection image can be obtained, which subsequently can be used for a reconstruction (e.g., an initial reconstruction).

The three-dimensional (3D) reconstruction system 614 may estimate a 3D model for the image data 602 and/or each image stack. Three-dimensional (3D) reconstruction system 614 can infer a relative angle between different particles or particle classes. When the angles are known, a tomographic reconstruction can be performed to obtain a 3D model.

The artificial intelligence model may be used to infer/generate a dataset descriptor 618 based on input that includes one or more image stacks and/or other information obtained using the one or more image stacks. The artificial intelligence model may have been trained to generate a dataset descriptor 618 that results in the best compression. In certain embodiments, the artificial intelligence model may be an image generation model (e.g., image generation model 704).

The downsampled image data may, for each image stack, be generated. A summed and downsampled image stack may be generated to be represented by the dataset descriptor 618. Reference image generation system 620 may then upsample the downsampled image stack to generate a reference stack 630.

The drift correction system 606, CTF estimation and correction system 608, particle picking system and/or feature segmentation system 610, particle classification system 612, three-dimensional (3D) reconstruction system 614, artificial intelligence model, downsampled image data, and/or denoised image data may be used by the attribute extraction system 616 to generate the dataset descriptor 618. The attribute extraction system 616 may extract data about the image data 602 from the data generated by the drift correction system 606, the CTF estimation and correction system 608, the particle picking system and/or the feature segmentation system 610, the particle classification system 612, the three-dimensional (3D) reconstruction system 614, the artificial intelligence model, and/or the downsampled image data. The extracted data may be included in a dataset descriptor 618.

In an example of attribute extraction system 616, attribute extraction system 616 collects all compact descriptive results from all processing steps (e.g., drift correction system 606, CTF estimation and correction system 608, etc.) and concatenate them into one dataset descriptor 618. The compact descriptive results may include the minimum description of what was produced by drift correction system 606, CTF estimation and correction system 608, etc. For example compact descriptive results may include particle picking: x,y coordinates and image number(s) while not including cropped and boxed particle images.

In an example, the dataset descriptor 618 includes coordinates and projection directions of particles, defocus, a drift profile, and/or a localization of dirt on the sample (e.g., sample 206). The dataset descriptor 618 may be generated for the image data 602 and/or each image stack included in the image data 602. The dataset descriptor 618 can be used to generate probability models for each spatio-temporal position in each image stack of the image data 602. In other words, the dataset descriptor 618 may represent the most likely particle positions and other sample information based on the information included in the image stacks of the image data 602. Dataset descriptor 618 may describe a dose used to acquire image data 602. The actual value may be encoded using the informed compression subsystem 632. In certain embodiments, the more accurate the dataset descriptor 618 is, the better/greater the expected compressions is for the image data 602 that is compressed and represented as compressed image data 634.

Reference image generation system 620 may use the dataset descriptor 618 to generate reference stacks 630. The reference stacks 630 may correspond to the image stacks included in the image data 602. Each reference stack 630 may represent the expected number of electrons for one or more points in spacetime. Each reference stack 630 may represent a 3D image. Reference image generation system 620 may perform inverse processing compared to the processing performed by the dataset description generation system 604. Reference image generation system 620 may use the dataset descriptor 618 to regenerate artificial micrographs which form an idealized noise-free estimate of the image stacks included in the image data 602.

Although reference image generation system 620 includes a projection system 622, a particle placement system 624, a CTF application system 626, and a stack creation system 628, a different combination of systems may be used (just as different combinations of systems are capable of being included in the dataset description generation system 604).

Informed compression subsystem 632 may receive reference stacks 630 generated by reference image generation system 620, image stacks included in image data 602, and the dataset descriptor 618. Informed compression subsystem 632 may include an entropy encoder. For example, the entropy encoder may be an arithmetic encoder, a Huffman encoder, or a range variant of asymmetric numeral systems (rANS) encoder, or another encoder. Informed compression subsystem 632 may generate compressed image data 634 representative of image data 602. Informed compression subsystem 632 may generate compressed image data 634 using a Poisson distribution. Dataset descriptor 618 in combination with running reference image generation system 620 may give the Poisson distribution giving the probability that N electrons will land on a respective pixel (e.g., by given the expected electron count for each pixel).

Informed compression subsystem 632 may generate the compressed image data 634 using the reference stack 630 as prior knowledge to improve the compression ratio. Informed compression subsystem 632 may encode the difference between the ideal data (e.g., represented by the reference stack 630) and the real data (represented by a corresponding stack included in the image data 602) instead of encoding the real data without prior knowledge. Informed compression subsystem 632 may use pixel intensities of the reference stack 630 as a lambda parameter of the Poisson distribution which gives the probability that N electrons will land on the respective pixel.

Informed compression subsystem 632 may also output the dataset descriptor 618 and/or other information generated and/or used by the compression system 516 to generate the compressed image data 634. For example, informed compression subsystem 632 may output the dataset descriptor 618. The dataset descriptor 618 may be used subsequently for decompressing the compressed image data 634.

The compression system 516 may enable extra compression compared to other compression techniques. The compression system 516 may be suitable for compressing image data 602 obtained by image data acquisition methods that deliver images with a large contrast difference, such as TEM imaging with a phase plate, dark field imaging techniques, and STEM iDPC. In conventional TEM imaging, the average number of electrons per pixel is large relative to the expected spread of number of electrons per pixel, leading to a marginal gain of compression factor when encoding electron events or small dose fractions. The compression system 516 may decrease memory space/resources used to represent the image data 602 and network resources used to transmit information representing the image data 602. The compression system 516 may be lossless in term of preserving information needed to obtain the highest possible reconstruction resolution.

FIG. 7 is a schematic diagram depicting an example of a generative adversarial network (GAN) 700 for training an image generation model 704, according to some embodiments. Image generation model 704 can be an example of an image encoding-decoding model. The image encoding-decoding model may be trained to define/generate encoded image data 706, based on received image data or a latent space 702 representing image data (e.g., real encoded image data 708). GAN 700 is a deep learning architecture. GAN 700 trains two neural networks, image generation model 704 and discrimination model 710, to compete against each other.

Image generation model 704 may be used to generate encoded image data 706 based on the latent space 702. In certain embodiments, generated encoded image data 706 can be generated from the latent space 702 and the latent space 702 may represent real encoded image data 708. In certain embodiments, generated encoded image data 706 can be generated using a fixed-length random vector from the latent space 702 representing image data as input and generate encoded image data 706. The fixed-length random vector may represent image data. The fixed-length random vector may include image data with randomly added noise based on an arbitrary noise distribution. The noise distribution can be sampled to obtain a batch of noise samples (noise vectors) to use as input image data to the image generation model 704.

The generated encoded image data 706 may be represented in a spatio-temporal resolution representation. Image data may be input to the image generation model 704. Image generation model 704 may be capable of consolidating damaged electron counted frames into a single denoised image. Image generation model 704 may generate encoded image data 706 with a data reduction compared to input image data received by the image generation model 704 and may do so without sacrificing the spatio-temporal resolution of the image data represented by the latent space.

The image generation model 704 and the discrimination model 710 train in an adversarial game, where the image generation model tries to generate encoded image data 706 and the discriminator model 710 attempts to predict if the encoded image data is fake/generated encoded image data 706 or real encoded image data 708. Real encoded image data 708 may include image data 108. The real encoded image data 708 may be image data generated by an image acquisition system (e.g., image acquisition system 106).

The discrimination model 710 analyzes the real encoded image data 708 and distinguishes between the attributes independently of the image generation model 704. The ground truth and the output of the discrimination model 710 may be used by the loss comparison system 712 to determine how to adjust the weights of the image generation model 704 and/or the discrimination model 710. The loss comparison system 712 may transmit a first weight adjustment signal 714 to the discrimination model 710 to cause weights of the discrimination model 710 to be adjusted with the goal of reducing the error of the discrimination model 710. Loss comparison system 712 may transmit a second weight adjustment signal 716 to the image generation model 704 to cause weights of the image generation model 704 to be adjusted with the goal of reducing the error of the image generation model 704.

After the image generation model 704 modifies some data attributes in the latent space 702 by adding noise (or random changes) to certain attributes. The image generation model 704 can pass the generated encoded image data 706 to the discrimination model 710. The discrimination model 710 calculates the probability that the generated encoded image data 706 belongs to the original dataset of real encoded image data 708. The discrimination model 710 gives some guidance to the image generation model 704 by performing a weight adjustment to parameters of the image generation model 704 using a second weight adjustment signal 716 to reduce the noise vector randomization in the next cycle. The image generation model 704 attempts to maximize the probability of mistake by the discrimination model 710, but the discrimination model 710 attempts to minimize the probability of error using the loss comparison system 712 that transmits the first weight adjustment signal 714 to the discrimination model 710 to update the weights used by the discrimination model 710. In training iterations, both the image generation model 704 and discrimination model 710 have their weights changed based on the weight adjustment signals transmitted by the loss comparison system 712 and are caused to evolve and confront each other continuously. Training iterations may continue until the image generation model 704 and the discrimination model 710 reach an equilibrium state. In the equilibrium state, the discrimination model 710 may no longer recognize synthesized data. At this point, the training process may be complete.

In certain embodiments, GAN 700 is a basic GAN architecture where image generation model 704 generates data variation with little or no feedback from the discrimination model 710. In certain embodiments, GAN 700 is a conditional GAN architecture where image generation model 704 and discrimination model 710 receive additional information, such as class labels or some other form of conditioning data. One of ordinary skill in the art with the benefit of the present disclosure would recognize other GAN architectures that may be used to train the image generation model 704 (e.g., a deep convolutional GAN, a Super-resolution GAN, etc.).

In certain embodiments, the image generation model 704 may be trained using other training techniques and may not be trained using a GAN. For example, the image generation model 704 may include a diffusion model, a stable diffusion model, a variational encoder, and/or an autoregressive model. In certain embodiments, image generation model 704 is trained to use at least a portion of acquisition settings (e.g., acquisition settings 502) to generate encoded image data 706.

Image generation model 704 may be trained such that image generation model 704 is capable of receiving image data and/or an embedding of image data in the latent space 702 and can output generated encoded image data 706. Image generation model 704 may be trained such that image data frames obtained from electrons interacting with a sample later than other image data frames obtained from electrons interacting with the sample are omitted partially or completely and reduce a volume of image data in the generated image data 708 compared to the volume of the image data. Image generation model 704 may use image data to generate encoded image data 708 that occupies less space in memory than the image data while not compromising the spatio-temporal resolution of generated encoded image data 708.

FIG. 8 is a schematic diagram depicting an example architecture of an image generation model 704, according to some embodiments. The image generation model 704 may have been trained according to techniques described with respect to FIG. 7. Image generation model 704 may have been trained to output encoded image data 804 based on received image data 802.

Image data 802 may include image data 108. Image data 802 may be received from an encoding selection system (e.g., encoding selection system 506) or an image acquisition system, (e.g., image acquisition system 106). In certain embodiments, image generation model 704 receives and uses one or more acquisition settings (e.g., acquisition settings 502) to generate encoded image data 804. In certain embodiments, encoded image data 804 is a compressed representation of image data 802.

Image generation model 704 may include any combination of layers. In an example, image generation model 704 may include an input layer 806, encoder blocks 808, a temporal context module 810, decoder blocks 812, a quantization layer 814, and/or an output layer 816. In certain embodiments, more or less (e.g., zero or more) of each layer may be included in the architecture of image generation model 704.

Input layer 806 may accept image data 802. The image data 802 may be represented as one or more image stacks (e.g., raw 3D slices from a cryoEM stack image acquisition system). Input layer 806 may apply a Fourier Transform to isolate frequency components.

Encoder blocks 808 may include 3D convolutional layers. Encoder blocks 808 may include swish activation and spatial dropout. The swish activation and spatial dropout may be performed after the 3D convolutional layers processing. Encoder blocks 808 can encode the input layer data into a lower-dimensional latent space.

Temporal context module 810 may use one or more recurrent neural networks (RNN) to capture temporal correlations between successive frames, enhancing the image generation model's 704 ability to differentiate between noise and structural data.

Decoder blocks 812 may utilize 3D transposed convolutions, swish activation, and/or batch normalization. Decoder blocks 812 may reconstruct the denoised image from the latent space.

Quantization layer 814 may quantize the denoised image to further reduce the file size (e.g., occupied memory space) without sacrificing crucial structural details of the image data 802.

Output layer: can produce the encoded image data 804. Encoded image data 804 may represent a high-quality and/or denoised image data that retains essential structural information of the image data 802. Encoded image data 804 may be a portion of an encoded image stack (e.g., an encoded 3D image slice).

The architecture of image generation model 704 and/or the training techniques used to train image generation model 704 can result in a significant data reduction compared to other methods of representing image data generated by an image acquisition system. Image generation model 704 may compress large sets of image data, such as reducing a 2TB dataset to 200GB, achieving a 90% data reduction. Image generation model 704 may preserve quality of the image data 802 in the encoded image data 804 and may do so despite the size reductions it can be capable of achieving. Retaining the quality of the image data 802 in the encoded image data 804 may retain critical structural information included in image data 802 and may not reduce data quality.

Using the image generation model 704 may increase speed and efficiency of generating encoded (e.g., compressed) image data 804 compared to other techniques of encoding image data 802 obtained from an image acquisition system. Computational, network, and/or storage resources may be reduced by the image generation model 704. For example, network and/or storage resources may be reduced by the generated compressed encoded image data 804. In another example, the computational resources of generating encoded image data 804 from image data 802 may be less than other methods of encoding image data 802 to achieve similar encoded image data. The image generation model 704 may be hosted on a local server and/or a remote server (e.g., in the cloud).

The processes 900, 1000, 1100, 1200, 1300, and 1400, depicted in flow diagrams and any other FIGS. may be implemented in software (e.g., code, instructions, program) executed by one or more processing units (e.g., processors, cores) of the respective systems, using hardware, or combinations thereof. The software may be stored on a non-transitory storage medium (e.g., on a memory device). The method presented in processes 900, 1000, 1100, 1200, 1300, and 1400, and other FIGS. and described herein are intended to be illustrative and non-limiting. Although processes 900, 1000, 1100, 1200, 1300, and 1400, and other FIGS, depict the various processing steps occurring in a particular sequence or order, this is not intended to be limiting. In certain alternative embodiments, the processing may be performed in some different order or some steps may also be performed in parallel. It should be appreciated that in alternative embodiments, the processes 900, 1000, 1100, 1200, 1300, and 1400, and other FIGS. may include a greater number or a lesser number of steps than those depicted in the respective FIGS.

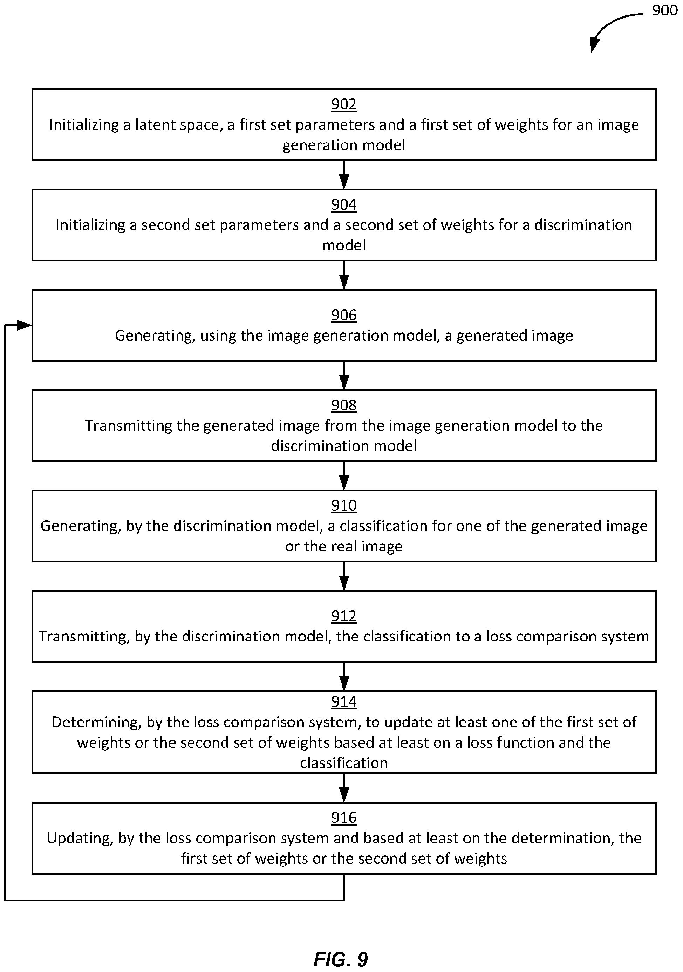

FIG. 9 is a flow diagram of an example process 900 for using a generative adversarial network (GAN) (e.g., GAN 700) with an image generation model and a discrimination model to train the image generation model (e.g., image generation model 704), according to some embodiments. The image generation model and the discrimination model can be trained using a training dataset comprising a plurality of batches of training examples.

At 902, a latent space, a first set of parameters, and a first set of weights may be initialized. The first set of parameters and the first set of weights may be for an image generation model and can affect the output generated by the image generation model. Each weight may be a value assigned to a corresponding parameter. In an example, image generation model may include a neural network. In an example, image generation model may be an image encoding-decoding model. In an example, the image generation model can receive a fixed-length random vector representing image data as input and generate encoded image data. The fixed-length random vector may represent image data. The fixed-length random vector may include image data with randomly added noise based on an arbitrary noise distribution. The noise distribution can be sampled to obtain a batch of noise samples (noise vectors) to use as input image data to the image generation model. The image generation model may be trained to generate encoded image data using received image data. The encoded image data may be compressed image data. The encoded image data may retain the quality of the image data in the encoded image data and may retain critical structural information included in the image data.

At 904, a second set of parameters, and a second set of weights may be initialized. The second set of parameters and the second set of weights may be for a discrimination model and can affect the output generated by the discrimination model. Each weight may be a value assigned to a corresponding parameter. The discrimination model may be a neural network. Each training example used by the discrimination model may include real encoded image data.

At 906, the fixed-length random vector may be input into the image generation model. The image generation model can then generate encoded image data based on the fixed-length random vector. The image generation model may output the generated encoded image data.

At 908, the generated encoded image data may be transmitted to the discrimination model. One or more encoded image data may be generated before being sent to the discrimination model (e.g., batch size) of a training phase. One or more encoded image data may be transmitted before each encoded image data is input to the discrimination model.

At 910, the discrimination model may be configured to generate a classification for the real encoded image data or the generated encoded image data. The discrimination model may generate more than one classification for more than one real encoded image data and/or generated encoded image data (e.g., depending on batch size). The classification may indicate whether the discrimination model has classified the received encoded image (real or generated) as real encoded image data or generated encoded image data.

At 912, the classification determined by the discrimination model may be transmitted to the loss comparison system.

At 914, the loss comparison system may compare the classification output by the discrimination model to ground truth data to determine whether the classification was correct. The loss comparison system may use any suitable loss function. In an embodiment, the image generation model and the discrimination model are trained in an adversarial manner using a loss function (e.g., Mean Square Error (MSE)).

Adversarial training means that the discrimination model and the image generation model are iteratively trained in turn. The discrimination model can be trained on both generated encoded image data received from the image generation model and real encoded image data from training examples. When the discrimination model improves to recognize the generated encoded image data as such (i.e., as "fake" images), the image generation model loss may be increasing. Thus, the image generation model is trained to reduce this loss.

At 916, the loss comparison system may transmit a weight adjustment signal to the image generation model or the discrimination model based on the classification output by the discrimination model and the ground truth.

The image generation model and the discrimination model may be trained by repeatedly (e.g., using back propagation) updating the first set of weights corresponding to the first set of parameters and/or updating the second set of weights corresponding to the second set of parameters. In certain embodiments, when the discrimination model correctly classifies a generated encoded image as a generated encoded image (e.g., not a real encoded image), one or more weights of the image generation model are adjusted.

The image generation model and the discrimination model may be trained by repeatedly updating weights of the parameters for the image generation model and the discrimination model until a loss function for the discrimination output is maximized with respect to the discrimination model and minimized with respect to the image generation model. One of ordinary skill in the art with the benefit of the present disclosure would recognize that other techniques for training a machine learning model to generate encoded image data could be used.

Steps 906-916 may be repeatedly performed based on how long training continues and/or the loss function used by the loss comparison system. Once the image generation model is trained, the image generation model may be used to generate encoded image data using image data.

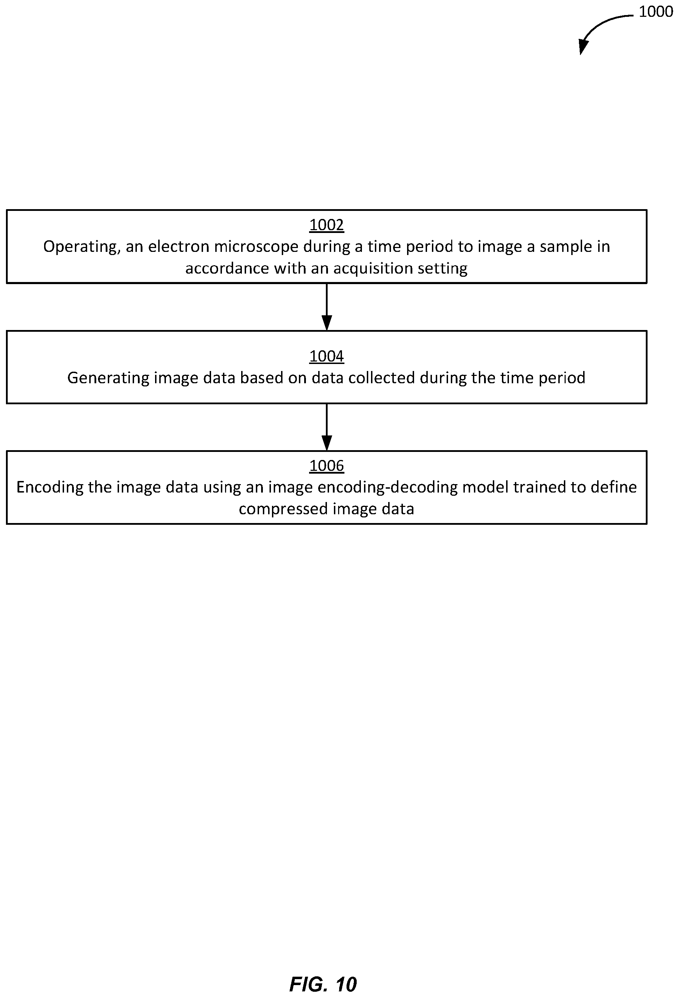

FIG. 10 is a flow diagram of an example process 1000 for generating encoded image data, according to some embodiments. The encoded image data may be generated using an image generation model (e.g., image generation model 704) during inference time.

At 1002, an image acquisition system (e.g., image acquisition system 106) may be operated to image a sample (e.g., a radiation sensitive sample). The image acquisition system may generate sample data based on data collected over a time period. The image acquisition system may be configured to operate according to one or more acquisition settings. The acquisition settings to operate using may be based on preconfigured acquisition settings, the sample, and/or user input. As an example, the acquisition settings may include a first dose rate and/or a first operating mode. The sample data collected during the time period may be image data and/or may be used to generate image data.

At 1004, image data is generated based on the sample data collected during the time period. In certain embodiments, such as where the sample data is the same as image data, this step may not be performed. Image data may include one or more electron counted frames.

At 1006, the image data may be encoded. The image data may be encoded using an encoding scheme. In certain embodiments, the encoding scheme may encode the image data using a machine learning model (e.g., an image encoding-decoding model). The machine learning model may compress the image data. In certain embodiments, the machine learning model may have been trained to encode the image data (e.g., trained using a GAN training architecture). By encoding the image data, the network, memory, and/or processing resources used by a system operating on and/or with image data may be reduced. For example, the image data before being encoded may have an image resolution represented using a first number of bits (e.g., a first amount of space in memory) and the encoded image data may have the same image resolution but use a second number of bits less than the first number of bits. In other words, the encoded image may occupy less space in memory than the image data which can reduce the network, memory, and/or processing resources used by a system operating on and/or with the encoded image data compared to the image data before being encoded.

In certain embodiments, the encoding scheme used at step 1006 is one of multiple encoding schemes available for encoding image data. In certain embodiments, the encoding scheme used at step 1006 is one of multiple encoding schemes used to encode respective portions of image data. For example, the encoding scheme performed during step 1006 may be performed for a first portion of image data and a different encoding scheme may be for a second and different portion of the image data.

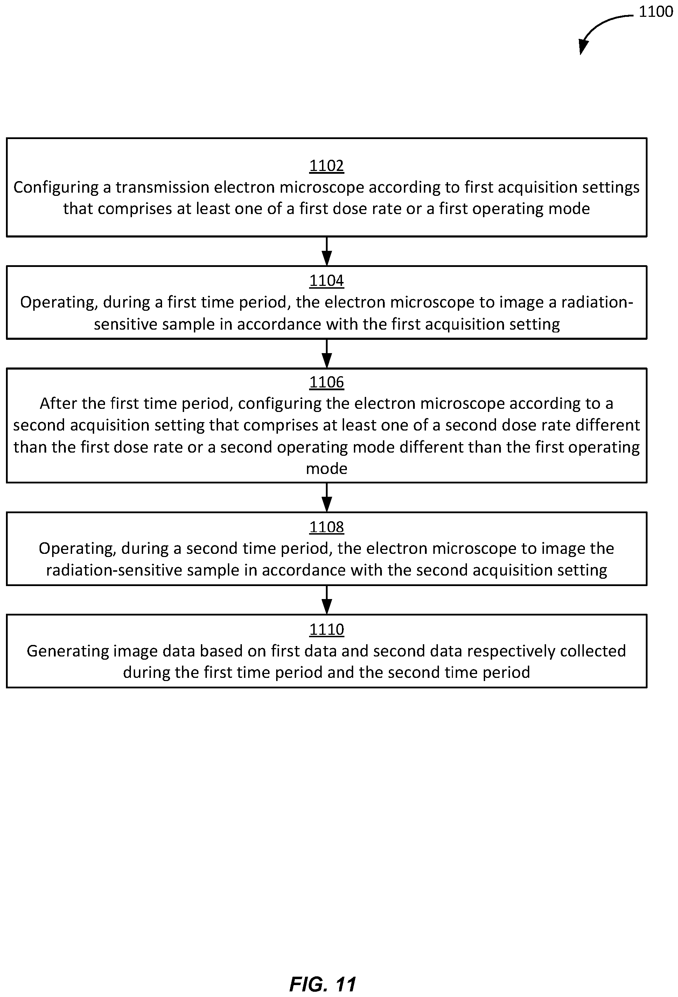

FIG. 11 is a flow diagram of an example process 1100 for acquiring image data, according to some embodiments. In certain embodiments, the process 1100 may be performed by an image acquisition system (e.g., image acquisition system 106). As described above, the image acquisition system may include an electron microscope. The image acquisition system may be used to obtain sample data and/or image data for an imaged sample (e.g., a radiation sensitive sample).

At 1102, the image acquisition system may be configured according to first acquisition settings. In certain embodiments, the first acquisition settings may include a first dose rate and/or a first operating mode (e.g., counting mode, integration mode). The first acquisition settings to operate with may be based on image acquisition settings received from another system, device, user interface, etc. The first acquisition settings to operate with may be based on predetermined acquisition settings that may have been previously configured. In certain embodiments, the acquisition settings may additionally or alternatively include a duration and/or a magnification.

At 1104, the acquisition system may operate during a first time period according to the first acquisition settings. The first time period may be a portion of a total time period the sample is imaged by the image acquisition system. The length of the first time period may be determined based on user input, the sample to image (expected and/or actual radiation damage to the sample), the operating mode, a dose rate used, a dose rate schedule, and/or a total time to image the sample, user input, a purpose for imaging the sample, a time dependent function (e.g., an exponential function, a linear function), etc.

The sample data obtained by the image acquisition system from the sample may have different characteristics during the first time period compared to a different second time period that is a portion of the total time period the sample is imaged. For example, when samples are radiation sensitive, the sample can degrade as dose is accumulated (e.g., as more electrons interact with the sample). Due to radiation damage, electrons detected at the end of an acquisition period can carry less information about the sample than the ones detected in the beginning of the acquisition period. The sample data acquired by operating during the first time period can be used to generate image data.

At 1106, the image acquisition system may be configured according to second acquisition settings. The image acquisition system may be configured according to second acquisition settings after the first time period. The second acquisition settings may be different than the first acquisition settings. In certain embodiments, the second acquisition settings may include a higher dose rate, a different operating mode, and/or other setting differences compared to the first acquisition settings. The second acquisition settings may be determined according to a time-dependent function, a purpose for imaging the sample, and/or the sample (e.g., expected radiation damage characteristics of the sample).

At 1108, the acquisition system may operate during a second time period according to the second acquisition settings. The second time period may be a portion of the total time period the sample is imaged by the image acquisition system. The length of the second time period may be determined based on the user input, the sample to image, the operating mode, the dose rate used, the dose rate schedule, and/or the total time to image the sample, etc. Second sample data obtained by the image acquisition system from the sample may have different characteristics than sample data obtained by the image acquisition system from the sample during the first time period.

At 1110, the first sample data and the second sample data obtained by the image acquisition system during the first time period and the second time period respectively, may be combined to generate image data. For the sake of simplicity, the illustrated process 1100 includes a first time period and second time period. However, in certain embodiments, more than two time periods are included in the total time period. In certain embodiments, more than two acquisition settings are used over the total time period. In certain embodiments, the image data is subsequently encoded (e.g., into a spatio-temporal representation, into a compressed representation)

As mentioned above, when the sample is radiation sensitive, the sample can degrade as dose is accumulated (e.g., as more electrons interact with the sample). Due to radiation damage, electrons detected at the end of an acquisition period can carry less information about the sample than the ones detected in the beginning of the acquisition period. Additionally, events detected in a high dose-rate frame can carry less information about the imaged sample than events detected in a low dose-rate frame. Furthermore, image data obtained from EMS 200 may be more accurate at lower dose rates than higher dose rates and the image quality (e.g., accuracy) of the image data may degrade as dose-rate increases. With the above in mind, certain embodiments herein (e.g., that adjust acquisition settings over the period that sample data is acquired) are capable of increasing the amount of information obtained from a sample in a given period of time. Certain embodiments can maximize the amount information obtained from a sample in a given period of time.

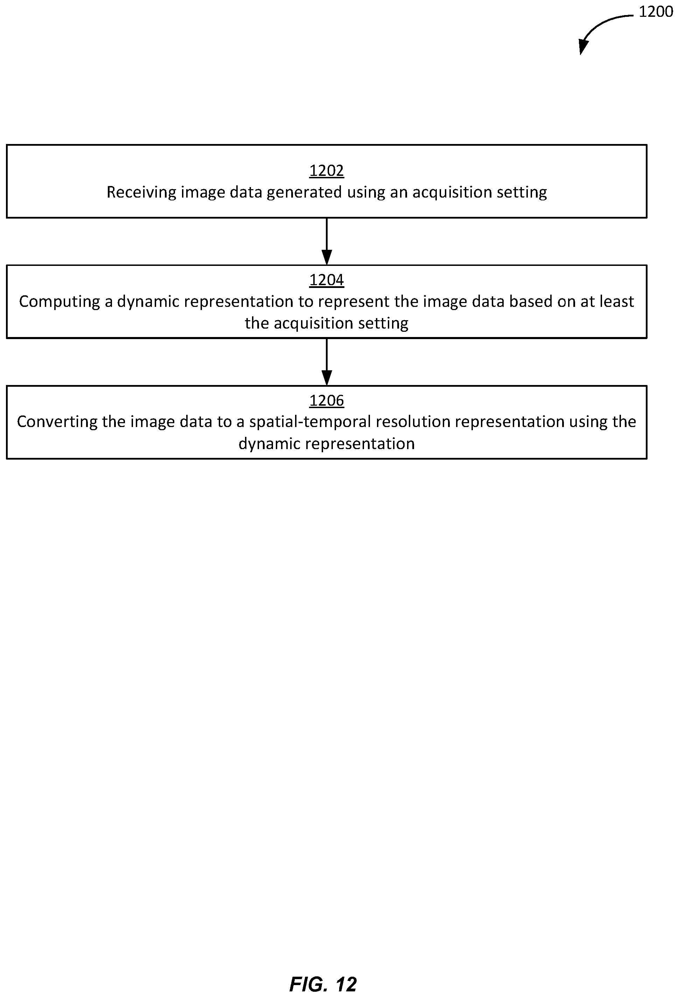

FIG. 12 is a flow diagram of an example process 1200 for encoding image data, according to some embodiments. Process 1200 may be performed by an image processing system (e.g., image processing system 110). Process 1200 may be performed by a first encoding system (e.g., first encoding system 504). Process 1200 may be performed on image data generated by an image acquisition system (e.g., image acquisition system 106).

At 1202, image data may be received. The image data may have been generated using the image acquisition system. The image data may have been generated based on the image acquisition system using acquisition settings. The image data may represent the image data obtained during a total time period the sample was imaged by the image acquisition system. The image data may represent the image data obtained during a portion of the total time period the sample was imaged by the image acquisition system. The image data may represent image frames or electron events.

At 1204, a dynamic representation to represent the image data is computed. The dynamic representation to use for representing the image data may be computed based on at least the acquisition settings used to obtain the image data. The dynamic representation may be an encoding scheme from a set of encoding schemes that is dynamically selected based on at least the acquisition settings used to obtain the image data. In other words, the image data may be encoded using an encoding scheme based on the acquisition settings used to obtain the image data. Step 1204 may be performed by an encoding selection system (e.g., encoding selection system 506).

At 1206, the image data may be converted into a spatio-temporal resolution representation using the dynamic representation computed during step 1204. The image data may be converted into the spatio-temporal resolution using an EER encoding scheme, a dose fractionation encoding scheme, using an image encoding-decoding model, or another encoding scheme capable of encoding the image data. The spatio-temporal resolution representation may be referred to as encoded image data.

The different encoding schemes can reduce the amount of memory occupied by the encoded image data and/or increase the spatio-temporal resolution of the encoded image data compared to using a different encoding scheme. By using an encoding scheme based on acquisition settings, the amount of memory occupied by the encoded image data can be minimized while also maximizing the spatio-temporal resolution of the encoded image data.

In certain embodiments, process 1200 may be used for two separate portions of image data. For example, process 1200 may be used for a first portion of image data to encode the first portion using a first encoding scheme. The first portion of image data may represent low dose image frame or electron events. Further, process 1200 may be used for a second portion of the image data different than the first portion of image data and the second encoding scheme may be different than the first encoding scheme. The second portion of image data may represent low dose image frame or electron events. In certain embodiments, the first portion of the image data may be different resolution (e.g., greater) than the second portion of image data (e.g., because of the acquisition settings used to generate the image data, because of accumulated dose to the sample, etc.). The second encoding scheme can produce an encoded image independent of the first encoding scheme. In certain embodiments, the second encoding scheme may generate the second encoded portion using an encoding scheme more lossy than the first encoding scheme.

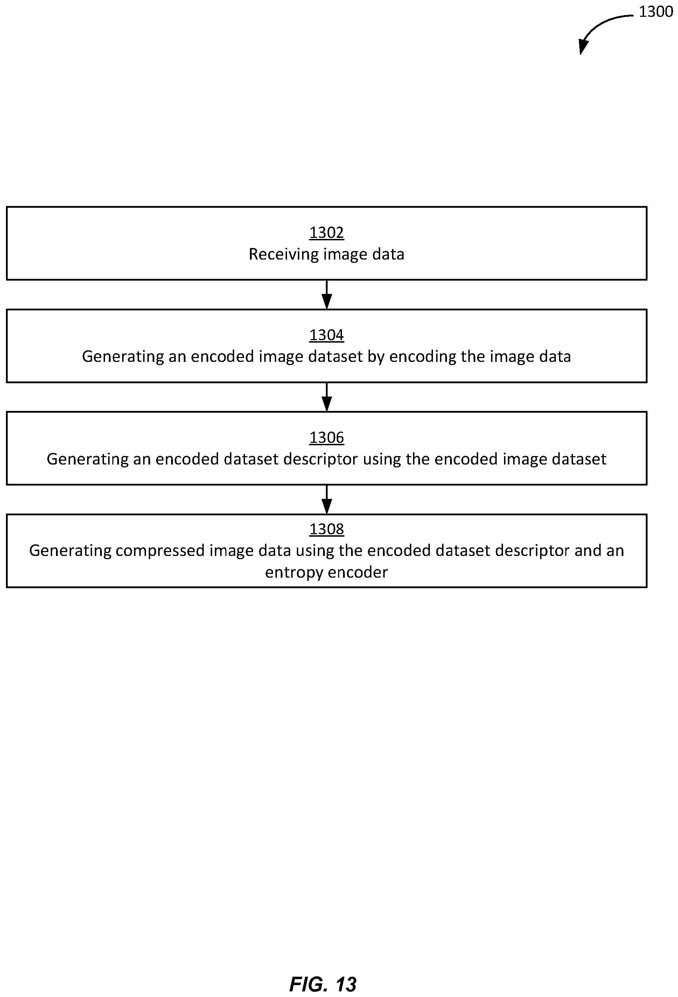

FIG. 13 is a flow diagram of an example process 1300 for compressing image data, according to some embodiments. The compression may result in a reduced amount of memory space being used to represent the image data. The compression may be lossless in terms of preserving all information needed to obtain the highest possible reconstruction resolution.

At 1302, image data may be received. The image data may include image stacks. An image stack may include data representing a set of images. The image data may have been received from an image acquisition system (e.g., image acquisition system 106), an encoding system (e.g., first encoding system 504), and/or memory, etc.

At 1304, the image data may be encoded. In certain embodiments, the image data may be encoded into the spatio-temporal resolution using an EER encoding scheme, a dose fractionation encoding scheme, using an image encoding-decoding model, or another encoding scheme capable of encoding the image data. In certain embodiments, the image data may be encoded based on acquisition settings used to obtain the image data.

At 1306, in certain embodiments, a dataset descriptor for the encoded image data may be generated. The dataset descriptor may be generated using a drift correction, a contrast transfer function correction, particle picking, feature segmentation, particle classification, three-dimensional reconstruction, an artificial intelligence model, downsampled image data, and/or denoised image data.

The dataset descriptor may be generated for the image data and/or each image stack included in the image data. The dataset descriptor can be used to generate probability models for each spatio-temporal position in each image stack of the image data. In other words, the dataset descriptor may represent the most likely particle positions and other sample information based on the information included in the image stacks of the image data. In certain embodiments, the more accurate the dataset descriptor is, the better/greater the expected compressions is for the image data that is compressed and represented as second encoded image data.

At 1308, in certain embodiments, compressed image data may be generated. Compressed image data may be generated using the dataset descriptor generated at step 1306 and an entropy encoder. The compressed image data may include compressed image stacks representing a set of one or more images. Generating the compressed image data using the dataset descriptor may include generating a three-dimensional reference image using the encoded dataset descriptor and/or the encoded image. The three-dimensional reference image may include an expected number of electrons for one or more points in space-time. In certain embodiments, the entropy encoder can be an arithmetic encoder, a Huffman encoder, or a range variant of asymmetric numeral systems (rANS) encoder.

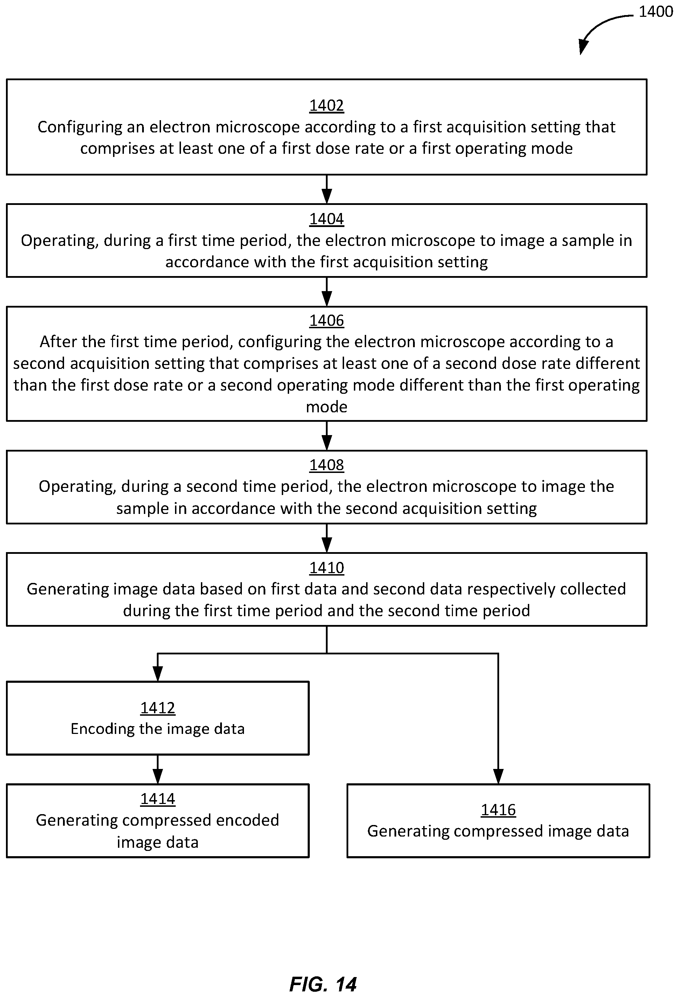

FIG. 14 is a flow diagram of an example process 1400 for acquiring image data and encoding the image data, according to some embodiments.

Steps 1402, 1404, 1406, 1408, and 1410 may be performed in a similar manner as steps 1102, 1104, 1106, 1108, and 1110, respectively, and which are described above. In certain embodiments, steps 1406 and 1408 are not performed and only a single set of acquisition settings is used to generate the image data.

At 1412, the image data generated at step 1410 may be encoded. The image data may be encoded using any encoding scheme described herein. For example, the image data may be encoded using an EER encoding scheme, a dose fractionation encoding scheme, using an image encoding-decoding model, using an image generation model (e.g., image generation model 704). As described above, in certain embodiments, different portions of the image data may be encoded with an encoding scheme based on the acquisition settings used to obtain the sample data.

At 1414, the encoded image data may be further encoded by compressing the encoded image data. Example compression schemes may include using a compression system (e.g., compressions system 516), an arithmetic encoder, a Huffman encoder, or a range variant of asymmetric numeral systems (rANS) encoder, or another encoder.

At 1416, the image data generated at step 1410 may be encoded such that it is compressed. Example compression schemes may include using an image generation model (e.g., image generation model 704), and/or a compression system (e.g., compressions system 516).

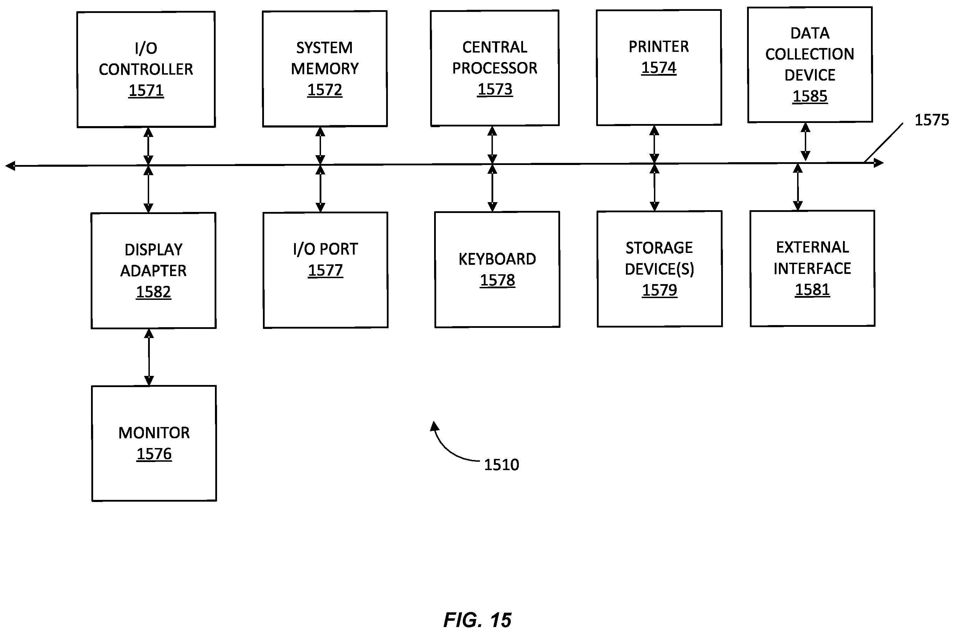

FIG. 15 depicts a schematic diagram of an example computer system usable with systems and methods according to some embodiments of the present disclosure.

Any of the computer systems mentioned herein (e.g., computing system 104, image acquisition system 106, etc.) may utilize any suitable number of subsystems. Examples of such subsystems are shown in FIG. 15 in computer system 1510. In some embodiments, a computer system includes a single computer apparatus, where the subsystems can be the components of the computer apparatus. In other embodiments, a computer system can include multiple computer apparatuses, each being a subsystem, with internal components. A computer system can include desktop and laptop computers, tablets, mobile phones and other mobile devices.

The subsystems shown in FIG. 15 are interconnected via a system bus 1575. Additional subsystems such as a printer 1574, keyboard 1578, storage device(s) 1579, monitor 1576 (e.g., a display screen, such as an LED), which is coupled to display adapter 1582, and others are shown. Peripherals and input/output (I/O) devices, which couple to I/O controller 1571, can be connected to the computer system by any number of means known in the art such as input/output (I/O) port 1577 (e.g., USB, FireWire^{®}). For example, I/O port 1577 or external interface 1581 (e.g., Ethernet, Wi-Fi, etc.) can be used to connect computer system 1510 to a wide area network such as the Internet, a mouse input device, or a scanner. The interconnection via system bus 1575 allows the central processor 1573 to communicate with each subsystem and to control the execution of a plurality of instructions from system memory 1572 or the storage device(s) 1579 (e.g., a fixed disk, such as a hard drive, or optical disk), as well as the exchange of information between subsystems. The system memory 1572 and/or the storage device(s) 1579 may embody a computer readable medium. Another subsystem is a data collection device 1585, such as a camera, microphone, accelerometer, and the like. Any of the data mentioned herein can be output from one component to another component and can be output to the user.

A computer system can include a plurality of the same components or subsystems, e.g., connected together by external interface 1581, by an internal interface, or via removable storage devices that can be connected and removed from one component to another component. In some embodiments, computer systems, subsystem, or apparatuses can communicate over a network. In such instances, one computer can be considered a client and another computer a server, where each can be part of a same computer system. A client and a server can each include multiple systems, subsystems, or components.

Aspects of embodiments can be implemented in the form of control logic using hardware circuitry (e.g., an application specific integrated circuit or field programmable gate array) and/or using computer software stored in a memory with a generally programmable processor in a modular or integrated manner, and thus a processor can include memory storing software instructions that configure hardware circuitry, as well as an FPGA with configuration instructions or an ASIC. As used herein, a processor can include a single-core processor, multicore processor on a same integrated chip, or multiple processing units on a single circuit board or networked, as well as dedicated hardware. Based on the disclosure and teachings provided herein, a person of ordinary skill in the art will know and appreciate other ways and/or methods to implement embodiments of the present disclosure using hardware and a combination of hardware and software.

Any of the software components or functions described in this application, such as process 900, 1000, 1100, 1200, 1300, and/or 1400, may be implemented as software code to be executed by a processor using any suitable computer language such as, for example, Java, C, C++, C#, Objective-C, Swift, or scripting language such as Perl or Python using, for example, conventional or object-oriented techniques. The software code may be stored as a series of instructions or commands on a computer readable medium for storage and/or transmission. A suitable non-transitory computer readable medium can include random access memory (RAM), a read only memory (ROM), a magnetic medium such as a hard-drive or a floppy disk, or an optical medium such as a compact disk (CD) or DVD (digital versatile disk) or Blu-ray disk, flash memory, and the like. The computer readable medium may be any combination of such devices. In addition, the order of operations may be re-arranged. A process can be terminated when its operations are completed, but could have additional steps not included in a figure. A process may correspond to a method, a function, a procedure, a subroutine, a subprogram, etc. When a process corresponds to a function, its termination may correspond to a return of the function to the calling function or the main function.

Such programs may also be encoded and transmitted using carrier signals adapted for transmission via wired, optical, and/or wireless networks conforming to a variety of protocols, including the Internet. As such, a computer readable medium may be created using a data signal encoded with such programs. Computer readable media encoded with the program code may be packaged with a compatible device or provided separately from other devices (e.g., via Internet download). Any such computer readable medium may reside on or within a single computer product (e.g., a hard drive, a CD, or an entire computer system), and may be present on or within different computer products within a system or network. A computer system may include a monitor, printer, or other suitable display for providing any of the results mentioned herein to a user.

Any of the methods described herein may be totally or partially performed with a computer system including one or more processors, which can be configured to perform the steps. Any operations performed with a processor (e.g., aligning, determining, comparing, computing, calculating) may be performed in real-time. The term "*real-time*" may refer to computing operations or processes that are completed within a certain time constraint. The time constraint may be 1 minute, 1 hour, 1 day, or 7 days. Thus, embodiments can be directed to computer systems configured to perform the steps of any of the methods described herein, potentially with different components performing a respective step or a respective group of steps. Although presented as numbered steps, steps of methods herein can be performed at a same time or at different times or in a different order. Additionally, portions of these steps may be used with portions of other steps from other methods. Also, all or portions of a step may be optional. Additionally, any of the steps of any of the methods can be performed with modules, units, circuits, or other means of a system for performing these steps.

In the foregoing specification, embodiments of the disclosure have been described with reference to numerous specific details that can vary from implementation to implementation. The specification and drawings are, accordingly, to be regarded in an illustrative rather than a restrictive sense. The sole and exclusive indicator of the scope of the disclosure, and what is intended by the applicants to be the scope of the disclosure, is the literal and equivalent scope of the set of claims that issue from this application, in the specific form in which such claims issue, including any subsequent correction. The specific details of particular embodiments can be combined in any suitable manner without departing from the spirit and scope of embodiments of the disclosure.

Terms "and," "or," and "an/or," as used herein, may include a variety of meanings that also is expected to depend at least in part upon the context in which such terms are used. Typically, "or" if used to associate a list, such as A, B, or C, is intended to mean A, B, and C, here used in the inclusive sense, as well as A, B, or C, here used in the exclusive sense. In addition, the term "one or more" as used herein may be used to describe any feature, structure, or characteristic in the singular or may be used to describe some combination of features, structures, or characteristics. However, it should be noted that this is merely an illustrative example and claimed subject matter is not limited to this example. Furthermore, the term "at least one of" if used to associate a list, such as A, B, or C, can be interpreted to mean any combination of A, B, and/or C, such as A, B, C, AB, AC, BC, AA, AAB, ABC, AABBCCC, etc.

Reference throughout this specification to "one example," "an example," "certain examples," or "exemplary implementation" means that a particular feature, structure, or characteristic described in connection with the feature and/or example may be included in at least one feature and/or example of claimed subject matter. Thus, the appearances of the phrase "in one example," "an example," "in certain examples," "in certain implementations," or other like phrases in various places throughout this specification are not necessarily all referring to the same feature, example, and/or limitation. Furthermore, the particular features, structures, or characteristics may be combined in one or more examples and/or features.

In some implementations, operations or processing may involve physical manipulation of physical quantities. Typically, although not necessarily, such quantities may take the form of electrical or magnetic signals capable of being stored, transferred, combined, compared, or otherwise manipulated. It has proven convenient at times, principally for reasons of common usage, to refer to such signals as bits, data, values, elements, symbols, characters, terms, numbers, numerals, or the like. It should be understood, however, that all of these or similar terms are to be associated with appropriate physical quantities and are merely convenient labels. Unless specifically stated otherwise, as apparent from the discussion herein, it is appreciated that throughout this specification discussions utilizing terms such as "processing," "computing," "calculating," "determining," or the like refer to actions or processes of a specific apparatus, such as a special purpose computer, special purpose computing apparatus or a similar special purpose electronic computing device. In the context of this specification, therefore, a special purpose computer or a similar special purpose electronic computing device is capable of manipulating or transforming signals, typically represented as physical electronic or magnetic quantities within memories, registers, or other information storage devices, transmission devices, or display devices of the special purpose computer or similar special purpose electronic computing device.

In the preceding detailed description, numerous specific details have been set forth to provide a thorough understanding of claimed subject matter. However, it will be understood by those skilled in the art that claimed subject matter may be practiced without these specific details. In other instances, methods and apparatuses that would be known by one of ordinary skill have not been described in detail so as not to obscure claimed subject matter. Therefore, it is intended that claimed subject matter not be limited to the particular examples disclosed, but that such claimed subject matter may also include all aspects falling within the scope of appended claims, and equivalents thereof.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

Where terms are used without explicit definition, it is understood that the ordinary meaning of the word is intended, unless a term carries a special and/or specific meaning in the field of charged particle microscopy systems or other relevant fields. The terms "approximately," "same," "about," "similar," or "substantially" are used to indicate a deviation from the stated property or numerical value within which the deviation has little to no influence of the corresponding function, property, or attribute of the structure being described. In an illustrated example, where a dimensional parameter is described as "substantially equal" or "approximate" to another dimensional parameter, the term "substantially" or "approximate" is intended to reflect that the two dimensions being compared can be unequal within a tolerable limit, such as a fabrication tolerance. Similarly, where a geometric parameter, such as an alignment or angular orientation, is described as "about" normal, "substantially" normal, or "substantially" parallel, "approximately" equal, "approximately" the same, the terms "about" or "substantially" or "approximately" are intended to reflect that the alignment or angular orientation can be different from the exact stated condition (e.g., not exactly normal) within a tolerable limit. For dimensional values, such as diameters, lengths, widths, or the like, the term "about" can be understood to describe a deviation from the stated value of up to ±10%. For example, a dimension of "about ten mm" can describe a dimension from nine mm to eleven mm. In the present disclosure, "sub-ranges" refers to a range of values between the two stated extents and/or including one of the two stated extents.

The description provides exemplary embodiments, and is not intended to limit the scope, applicability or configuration of the disclosure. Rather, the ensuing description of the exemplary embodiments will provide those skilled in the art with an enabling description for implementing various embodiments. It is understood that various changes may be made in the function and arrangement of elements without departing from the spirit and scope as set forth in the appended claims.

Specific details are given in the description to provide a thorough understanding of the embodiments. However, it will be understood that the embodiments may be practiced without these specific details. For example, specific system components, systems, processes, and other elements of the present disclosure may be shown in schematic diagram form or omitted from illustrations in order not to obscure the embodiments in unnecessary detail. In other instances, well-known circuits, processes, components, structures, and/or techniques may be shown without unnecessary detail.

As used in this application and in the claims, the singular forms "a", "an", and "the" include the plural forms unless the context clearly dictates otherwise. Additionally, the term "includes" means "comprises." Further, the term "coupled" does not exclude the presence of intermediate elements between the coupled items.

The systems, apparatuses, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatuses are not limited to any specific aspect or feature or combinations thereof, nor do the disclosed systems, methods, and apparatuses require that any one or more specific advantages be present or problems be solved. Any theories of operation are to facilitate explanation, but the disclosed systems, methods, and apparatuses are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatuses can be used in conjunction with other systems, methods, and apparatuses. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one or ordinary skill in the art.

The following numbered clauses describe embodiments of the present disclosure:
1. A computer-implemented method comprising:
   configuring a transmission electron microscope according to first acquisition settings that comprises at least one of a first dose rate or a first operating mode;
   operating, during a first time period, the transmission electron microscope to image a radiation-sensitive sample in accordance with the first acquisition settings;
   after the first time period, configuring the transmission electron microscope according to second acquisition settings that comprises at least one of a second dose rate different than the first dose rate or a second operating mode different than the first operating mode;
   operating, during a second time period, the transmission electron microscope to image the radiation-sensitive sample in accordance with the second acquisition settings; and
   generating image data based on first data and second data respectively collected during the first time period and the second time period.
2. The computer-implemented method of clause 1, wherein the first operating mode comprises a counting mode or an integrating mode.
3. The computer-implemented method of clause 1 or clause 2, wherein the first acquisition settings comprise the first dose rate, and wherein the second acquisition settings comprise the second dose rate.
4. The computer-implemented method of any preceding clause, wherein the second dose rate is greater than the first dose rate.
5. The computer-implemented method of any preceding clause, wherein the second acquisition settings is determined according to at least one of: a time-dependent function or an expected radiation damage characteristic of the radiation-sensitive sample.
6. The computer-implemented method of any preceding clause, wherein the first time period is determined based on a rate of radiation damage to the radiation-sensitive sample.
7. The computer-implemented method of any preceding clause, wherein the first time period is determined based on at least one of the first dose rate or the first operating mode.
8. The computer-implemented method of any preceding clause, wherein the first data was collected using a first frame rate and the second data was collected using a second frame rate lower than the first frame rate.
9. The computer-implemented method of any preceding clause, wherein at least one of the first acquisition settings or the second acquisition settings further comprises at least one of: a duration or a magnification.
10. The computer-implemented method of any preceding clause, wherein the image data comprises a plurality of electron counted frames, the method further comprising:
   encoding the image data using an image encoding-decoding model trained to define encoded image data.
11. The computer-implemented method of clause 10, wherein the image data comprises an image resolution represented using a first number of bits and the encoded image data comprises the image resolution using a second number of bits less than the first number of bits.
12. A non-transitory computer-readable storage medium comprising instructions that are executable by one or more processors of a transmission electron microscope for causing operations comprising:
   configuring the transmission electron microscope according to first acquisition settings that comprises at least one of a first dose rate or a first operating mode;
   operating, during a first time period, the transmission electron microscope to image a radiation-sensitive sample in accordance with the first acquisition settings;
   after the first time period, configuring the transmission electron microscope according to second acquisition settings that comprises at least one of a second dose rate different than the first dose rate or a second operating mode different than the first operating mode;
   operating, during a second time period, the transmission electron microscope to image the radiation-sensitive sample in accordance with the second acquisition settings; and
   generating image data based on first data and second data respectively collected during the first time period and the second time period.
13. The non-transitory computer-readable storage medium of clause 12, wherein the operations further comprise:
   computing a first dynamic representation to represent the first data based on at least the first acquisition settings;
   converting the first data to a first spatio-temporal resolution representation using the first dynamic representation;
   computing a second dynamic representation to represent the second data based on at least the second acquisition settings;
   converting the second data to a second spatio-temporal resolution representation using the second dynamic representation;
   generating first compressed image data using a first compression scheme with the first spatio-temporal resolution representation; and
   generating second compressed image data using a second compression scheme with the second spatio-temporal resolution representation.
14. The non-transitory computer-readable storage medium of clause 13, wherein a first resolution of the first spatio-temporal resolution representation is greater than a second resolution of the second spatio-temporal resolution representation.
15. The non-transitory computer-readable storage medium of clause 13 or clause 14, wherein the first compression scheme is determined based on the first dynamic representation and the second compression scheme is determined based on the second dynamic representation.
16. The non-transitory computer-readable storage medium of any of clauses 13 to 15, wherein the second compression scheme is more lossy than the first compression scheme.
17. The non-transitory computer-readable storage medium of any of clauses 13 to 16, wherein converting the first data to the first spatio-temporal resolution representation using the first dynamic representation comprises:
   performing an encoding using at least one of: an electron event representation, a dose fractionation scheme, or an entropy coder and a probability model; and
   wherein converting the second data to the second spatio-temporal resolution representation using the second dynamic representation comprises:
      performing a second encoding using at least one of: the electron event representation, the dose fractionation scheme, or the entropy coder and the probability model.
18. The non-transitory computer-readable storage medium of any of clauses 13 to 17, wherein the first data represents low dose image frames or electron events and the second data represents low dose image frames or electron events.
19. The non-transitory computer-readable storage medium of any of clauses 13 to 18, wherein an indication of at least one of the first dynamic representation or the second dynamic representation is received from a graphical user interface of a user device.
20. The non-transitory computer-readable storage medium of any of clauses 13 to 19, wherein the operations further comprise:
   generating an encoded image dataset by encoding second image data including at least one of: the first spatio-temporal resolution representation or the second spatio-temporal resolution representation;
   generating an encoded dataset descriptor using the encoded image dataset and at least one of: a drift correction, a contrast transfer function correction, particle picking, feature segmentation, particle classification, three-dimensional reconstruction, or an artificial intelligence model;
   generating a three-dimensional reference image using the encoded dataset descriptor and the encoded image dataset; and
   generating compressed second image data using the three-dimensional reference image, the encoded dataset descriptor, and an entropy encoder.
21. A transmission electron microscope comprising:
   one or memories storing instructions; and
   one or more processors configured to execute the instructions to cause the transmission electron microscope to perform operations comprising:
      configuring the transmission electron microscope according to first acquisition settings that comprises at least one of a first dose rate or a first operating mode;
      operating, during a first time period, the transmission electron microscope to image a radiation-sensitive sample in accordance with the first acquisition settings;
      after the first time period, configuring the transmission electron microscope according to second acquisition settings that comprises at least one of a second dose rate different than the first dose rate or a second operating mode different than the first operating mode;
      operating, during a second time period, the transmission electron microscope to image the radiation-sensitive sample in accordance with the second acquisition settings; and
      generating image data based on first data and second data respectively collected during the first time period and the second time period.
22. The transmission electron microscope of clause 21, further comprising:
   generating an encoded image dataset by encoding the image data;
   generating an encoded dataset descriptor using the encoded image dataset and at least one of: a drift correction, a contrast transfer function correction, particle picking, feature segmentation, particle classification, three-dimensional reconstruction, an artificial intelligence model, downsampled image data, or denoised image data; and
   generating compressed image data using the encoded dataset descriptor and an entropy encoder.
23. The transmission electron microscope of clause 22, wherein generating the compressed image data using the encoded dataset descriptor comprises:
   generating a three-dimensional reference image using the encoded dataset descriptor and the encoded image dataset.
24. The transmission electron microscope of clause 23, wherein the three-dimensional reference image includes an expected number of electrons for one or more points in space-time.
25. The transmission electron microscope of any of clauses 22 to 24, wherein the image data comprises an image stack including data representing a plurality of images.

## Claims

1. A computer-implemented method comprising:
configuring a transmission electron microscope according to first acquisition settings that comprises at least one of a first dose rate or a first operating mode;
operating, during a first time period, the transmission electron microscope to image a radiation-sensitive sample in accordance with the first acquisition settings;
after the first time period, configuring the transmission electron microscope according to second acquisition settings that comprises at least one of a second dose rate different than the first dose rate or a second operating mode different than the first operating mode;
operating, during a second time period, the transmission electron microscope to image the radiation-sensitive sample in accordance with the second acquisition settings; and
generating image data based on first data and second data respectively collected during the first time period and the second time period.

2. The computer-implemented method of claim 1, wherein the first operating mode comprises a counting mode or an integrating mode.

3. The computer-implemented method of claim 1 or claim 2, wherein the first acquisition settings comprise the first dose rate, and wherein the second acquisition settings comprise the second dose rate.

4. The computer-implemented method of any preceding claim, wherein: the second dose rate is greater than the first dose rate; and/or the second acquisition settings is determined according to at least one of: a time-dependent function or an expected radiation damage characteristic of the radiation-sensitive sample.

5. The computer-implemented method of any preceding claim, wherein: the first time period is determined based on a rate of radiation damage to the radiation-sensitive sample; and/or the first time period is determined based on at least one of the first dose rate or the first operating mode.

6. The computer-implemented method of any preceding claim, wherein: the first data was collected using a first frame rate and the second data was collected using a second frame rate lower than the first frame rate; and/or at least one of the first acquisition settings or the second acquisition settings further comprises at least one of: a duration or a magnification.

7. The computer-implemented method of any preceding claim, wherein the image data comprises a plurality of electron counted frames, the method further comprising:
encoding the image data using an image encoding-decoding model trained to define encoded image data, optionally wherein the image data comprises an image resolution represented using a first number of bits and the encoded image data comprises the image resolution using a second number of bits less than the first number of bits.

8. A non-transitory computer-readable storage medium comprising instructions that are executable by one or more processors of a transmission electron microscope for causing operations comprising:
configuring the transmission electron microscope according to first acquisition settings that comprises at least one of a first dose rate or a first operating mode;
operating, during a first time period, the transmission electron microscope to image a radiation-sensitive sample in accordance with the first acquisition settings;
after the first time period, configuring the transmission electron microscope according to second acquisition settings that comprises at least one of a second dose rate different than the first dose rate or a second operating mode different than the first operating mode;
operating, during a second time period, the transmission electron microscope to image the radiation-sensitive sample in accordance with the second acquisition settings; and
generating image data based on first data and second data respectively collected during the first time period and the second time period.

9. The non-transitory computer-readable storage medium of claim 8, wherein the operations further comprise:
computing a first dynamic representation to represent the first data based on at least the first acquisition settings;
converting the first data to a first spatio-temporal resolution representation using the first dynamic representation;
computing a second dynamic representation to represent the second data based on at least the second acquisition settings;
converting the second data to a second spatio-temporal resolution representation using the second dynamic representation;
generating first compressed image data using a first compression scheme with the first spatio-temporal resolution representation; and
generating second compressed image data using a second compression scheme with the second spatio-temporal resolution representation, optionally wherein: a first resolution of the first spatio-temporal resolution representation is greater than a second resolution of the second spatio-temporal resolution representation; and/or the first compression scheme is determined based on the first dynamic representation and the second compression scheme is determined based on the second dynamic representation.

10. The non-transitory computer-readable storage medium of claim 9, wherein the second compression scheme is more lossy than the first compression scheme.

11. The non-transitory computer-readable storage medium of claim 9 or claim 10, wherein converting the first data to the first spatio-temporal resolution representation using the first dynamic representation comprises:
performing an encoding using at least one of: an electron event representation, a dose fractionation scheme, or an entropy coder and a probability model; and
wherein converting the second data to the second spatio-temporal resolution representation using the second dynamic representation comprises:
performing a second encoding using at least one of: the electron event representation, the dose fractionation scheme, or the entropy coder and the probability model.

12. The non-transitory computer-readable storage medium of any of claims 9 **to 11,** wherein any one or more of conditions (i), (ii) and (iii) applies:
(i) the first data represents low dose image frames or electron events and the second data represents low dose image frames or electron events;
(ii) an indication of at least one of the first dynamic representation or the second dynamic representation is received from a graphical user interface of a user device; and
(iii) the operations further comprise:
generating an encoded image dataset by encoding second image data including at least one of: the first spatio-temporal resolution representation or the second spatio-temporal resolution representation;
generating an encoded dataset descriptor using the encoded image dataset and at least one of: a drift correction, a contrast transfer function correction, particle picking, feature segmentation, particle classification, three-dimensional reconstruction, or an artificial intelligence model;
generating a three-dimensional reference image using the encoded dataset descriptor and the encoded image dataset; and
generating compressed second image data using the three-dimensional reference image, the encoded dataset descriptor, and an entropy encoder.

13. A transmission electron microscope comprising:
one or memories storing instructions; and
one or more processors configured to execute the instructions to cause the transmission electron microscope to perform operations comprising:
configuring the transmission electron microscope according to first acquisition settings that comprises at least one of a first dose rate or a first operating mode;
operating, during a first time period, the transmission electron microscope to image a radiation-sensitive sample in accordance with the first acquisition settings;
after the first time period, configuring the transmission electron microscope according to second acquisition settings that comprises at least one of a second dose rate different than the first dose rate or a second operating mode different than the first operating mode;
operating, during a second time period, the transmission electron microscope to image the radiation-sensitive sample in accordance with the second acquisition settings; and
generating image data based on first data and second data respectively collected during the first time period and the second time period.

14. The transmission electron microscope of claim 13, further comprising:
generating an encoded image dataset by encoding the image data;
generating an encoded dataset descriptor using the encoded image dataset and at least one of: a drift correction, a contrast transfer function correction, particle picking, feature segmentation, particle classification, three-dimensional reconstruction, an artificial intelligence model, downsampled image data, or denoised image data; and
generating compressed image data using the encoded dataset descriptor and an entropy encoder, optionally wherein generating the compressed image data using the encoded dataset descriptor comprises:
generating a three-dimensional reference image using the encoded dataset descriptor and the encoded image dataset, optionally wherein the three-dimensional reference image includes an expected number of electrons for one or more points in space-time.

15. The transmission electron microscope of claim 13 or claim 14, wherein the image data comprises an image stack including data representing a plurality of images.
